# EUROPÄISCHE PATENTSCHRIFT

(11) **EP 1 558 662 B1**
(45) Veröffentlichungstag und Bekanntmachung des Hinweises auf die Patenterteilung: **13.12.2006**
(21) Anmeldenummer: 03776866.0
(22) Anmeldetag: 17.10.2003
(51) Int. Cl.: C08G 61/12, C08G 73/02, C09K 11/06

(54) **ARYLAMIN-EINHEITEN ENTHALTENDE KONJUGIERTE POLYMERE, DEREN DARSTELLUNG UND VERWENDUNG**
CONJUGATED POLYMERS CONTAINING ARYLAMINE UNITS, THE REPRESENTATION THEREOF AND THE USE OF THE SAME
POLYMERES CONJUGUES CONTENANT DES UNITES D'ARYLAMINE, LEUR REPRESENTATION ET LEUR UTILISATION

(30) Priorität: 25.10.2002 DE 10249723
(43) Veröffentlichungstag der Anmeldung: 03.08.2005
(73) Patentinhaber: Merck Patent GmbH, 64293 Darmstadt (DE)
(72) Erfinder: BÜSING, Arne, 65929 Frankfurt am Main (DE); BREUNING, Esther, 65817 Eppstein-Niederjosbach (DE); SPREITZER, Hubert, 68519 Viernheim (DE); BECKER, Heinrich, 65817 Eppstein-Niederjosbach (DE); HAASE, Corinna, 60529 Frankfurt am Main (DE)
(86) Internationale Anmeldenummer: PCT/EP2003/011510
(87) Internationale Veröffentlichungsnummer: WO 2004/037887

(56) Entgegenhaltungen:
- EP-A- 0 973 210
- US-A- 5 814 244
- DATABASE WPI Section Ch, Week 200277 Derwent Publications Ltd., London, GB; Class E14, AN 2002-709828 XP002275750 & JP 2002 237384 A (TOYOTA CHUO KENKYUSHO KK) 23. August 2002 (2002-08-23)

## Beschreibung

Seit ca. 12 Jahren läuft eine breit angelegte Forschung zur Kommerzialisierung von Anzeige- und Beleuchtungselementen auf Basis Polymerer (Organischer) Leuchtdioden (PLEDs). Ausgelöst wurde diese Entwicklung durch die Grundlagenentwicklungen, welche in EP 423 283 (WO 90/13148) offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit marktbeherrschenden Flüssigkristallanzeigen (LCD) zu machen bzw. diese zu überflügeln. Vor allem ist es hierbei erforderlich, Polymere für alle Emissionsfarben (Rot, Grün, Blau) zur Verfügung zu stellen, die den Anforderungen des Marktes (Farbsättigung, Effizienz, Operative Lebensdauer, um die wichtigsten zu nennen) gerecht werden.

Als Polymere für vollfarbige Anzeigeelemente (sog. Full-Color-Displays) wurden bereits verschiedene Materialklassen vorgeschlagen bzw. entwickelt. So kommen Poly-Fluoren-Derivate, wie diese beispielsweise in EP-A-0 842 208, WO 99/54385, WO 00/22027, WO 00/22026 und WO 00/46321 offenbart werden, in Betracht. Des weiteren sind auch Poly-Spirobifluoren-Derivate, wie in EP-A-0 707 020, EP-A-0 894 107 und WO 03/020790 offenbart, eine Möglichkeit. Auch Polymere, die eine Kombination der beiden erstgenannten Strukturelemente enthalten, wie in WO 02/077060 offenbart, wurden bereits vorgeschlagen. Im allgemeinen sind für derartigen Einsatz Polymere, welche Poly-paraphenylen (PPP) als Strukturelement enthalten, möglich. Neben den oben bereits genannten Klassen kommen hier beispielsweise auch die sogenannten Leiter-PPPs ("Ladder-PPPs" = LPPP) (z. B. gemäß WO 92/18552), die Poly-tetrahydropyrene (z. B. gemäß EP-A-699699), aber auch Ansa-Strukturen enthaltende PPPs (z. B. gemäß EP-A-690086) in Frage.

Wie in einigen der o. g. Anmeldeschriften bereits heraus gearbeitet wurde, ist es für die Erzeugung aller drei Emissionsfarben notwendig, bestimmte Comonomere in die entsprechenden Polymere einzupolymerisieren (vgl. z. B. WO 00/46321, DE 10143353.0 und WO 02/077060). So ist dann i. d. R. - ausgehend von einem blau emittierenden Grundpolymer ("backbone") - die Erzeugung der beiden anderen Primärfarben Rot und Grün möglich.

Des weiteren wurde berichtet, daß das Einfügen bestimmter Aryl-amino-Gruppierungen eine Verbesserung der Eigenschaften ergibt:
- WO 99/54385 beschreibt Polyfluorene, deren Effizienz und Einsatzspannung verbessert werden kann, indem Derivate von Triphenylamin, Tetraphenyl-p-diamino-benzol oder Tetraphenyl-4,4'-diamino-biphenyl in die Hauptkette der entsprechenden Polymere mit einpolymerisiert werden.
- DE-A-19846767 beschreibt Polyfluorene, bei denen ebenfalls die Effizienz und Einsatzspannung verbessert wird, indem substituierte Diarylamino-Einheiten in die Hauptkette eingebaut werden.
- WO 01/49769 beschreibt allgemein Polymere, welche Triarylamino-Gruppen enthalten, bei welchen mindestens eine Arylgruppe eine Heteroarylgruppe darstellt. Besondere Vorteile dieser Polymere werden nicht beschrieben.
- WO 01/66618 beschreibt Copolymere, welche neben Aryleinheiten auch spezielle Triarylamino- bzw. Tetraaryl-p-diamino-arylen-einheiten in der Hauptkette enthalten. Die entsprechenden Aminobausteine enthalten dabei jeweils mit Trifluormethylgruppen substituierte Phenyle, die direkt an die Stickstoffatome gebunden sind, allerdings nicht in die Hauptkette eingebaut werden. Als Vorteil wird erwähnt, daß diese Materialien - v. a. im Gegensatz zu den Derivaten, welche in der o. g. WO 99/54385 genannt werden - eine besser einstellbare HOMO-Lage besitzen, und dies deshalb in der Anwendung Vorteile erbringt.

Trotz der in den o. g. Anmeldeschriften zitierten Fortschritte gibt es immer noch einen erheblichen Bedarf an Verbesserung für entsprechende Materialien. V. a. auf folgenden Feldern ist noch ein deutlicher Verbesserungsbedarf zu sehen:
- Die operative Lebensdauer, v. a. bei BLAU emittierenden Polymeren, bedarf immer noch einer deutlichen Verbesserung, um diese für marktgerechte Anwendungen einsetzen zu können.
- Die Effizienz, vor allem bei hohen Leuchtdichten, ist bei allen Farben noch verbesserungsbedürftig. Dies ist vor allem für die Verwendung in sogenannten Passiv-Matrix (PM) gesteuerten Displays von entscheidender Bedeutung: In diesen PM-Displays, wird jeder einzelne Bildpunkt (Pixel) nur einen Bruchteil der Zeit angesteuert (dieser Bruchteil wird mit der sogenannten Multiplex-Rate (MUX) bezeichnet). Ein MUX-64 bzw. MUX-128 Display bedeutet, daß jeder einzelne Pixel nur 1/64 bzw. 1/128 der Gesamtzeit angesteuert wird. Um trotzdem die gewünschte Helligkeit zu erhalten, muß in dieser kurzen Zeit der jeweilige Pixel mit dem selben Faktor (also in diesen Fällen 64 bzw. 128) heller leuchten, als dies für die gewünschte Helligkeit eigentlich nötig wäre. Will man also beispielsweise eine Pixel mit einer Durchschnittshelligkeit von 200 Cd/m² betreiben, benötigt man kurzfristig 12800 bzw. gar 25600 Cd/m². Durch die Trägheit des menschlichen Auges erhält der Betrachter dann - bei geeigneter Ansteuerung - den Eindruck des durchschnittlichen Helligkeitswertes. Problem bei dieser Ansteuerung ist nun derzeit folgendes: Die bisher benutzten Polymere, gerade für Vollfarb-Displays, weisen eine starke Abhängigkeit der Effizienz von der benötigten Helligkeit auf; beispielsweise zeigt ein BLAU-emittierendes Polymer (mit CIE1931-Farbkoordinaten von X = 0.15, Y = 0.16; vgl. Beispiel V1) einen Verlust an Effizienz von mehr als einen Faktor 2 beim Übergang von 200 Cd/m² zu einer Helligkeit von 30000 m² (vgl. auch Angaben in Tabelle 2 im Experimentellen Teil). Wie hieraus leicht ersichtlich ist, bedeutet die Verwendung eines derartigen Polymers große Schwierigkeiten für PM-angesteuerte Displays.

Wie aus dieser Beschreibung des Stands der Technik ersichtlich ist, besteht daher weiterhin ein großer Bedarf an Weiterentwicklung auf dem Gebiet der lichtemittierenden Polymere.

Wir haben nun überraschend gefunden, daß Polymere, die bestimmte - bisher unbekannte Arylamino-Einheiten enthalten - deutliche Verbesserungen, gerade auf den beiden o. g. Gebieten, d. h. der operativen Lebensdauer und der Effizienz bei hohen Leuchtdichten, ergeben. Diese sind daher Gegenstand der vorliegenden Anmeldung.

Gegenstand der Erfindung sind daher konjugierte Polymere, die mindestens 1 mol%, bevorzugt mindestens 5 mol%, ganz besonders bevorzugt mindestens 10 mol% Einheiten gemäß Formel (I) enthalten, 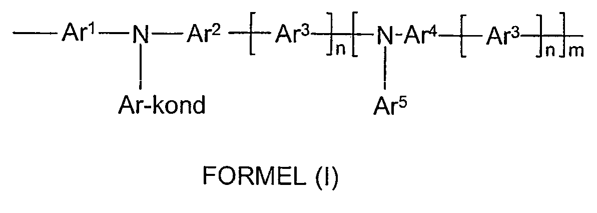 wobei die Symbole und Indizes folgende Bedeutung besitzen:
- Ar¹, Ar³: sind bei jedem Auftreten gleich oder verschieden einem aromatischen oder heteroaromatischen Ringsystem mit 2 bis 40 C-Atomen, welches substituiert oder auch unsubstituiert sein kann; die möglichen Substituenten R1 können dabei potentiell an jeder freien Position sitzen;
- Ar², Ar⁴: sind bei jedem Auftreten gleich oder verschieden Ar¹, Ar³ oder eine substituierte oder unsubstituierte Stilbenylen- bzw. Tolanyleneinheit;
- Ar-kond: ist bei jedem Auftreten gleich oder verschieden einem aromatischen oder heteroaromatischen Ringsystem, welches mindestens 9, höchstens aber 40 Atome (C- oder Heteroatome) im konjugierten System besitzt, welches substituiert oder auch unsubstituiert sein kann und welches aus mindestens zwei kondensierten Ringen besteht; die möglichen Substituenten R1 können dabei potentiell an jeder freien Position sitzen;
- Ar⁵: ist gleich oder verschieden bei jedem Auftreten entweder einem aromatischen oder heteroaromatischen Ringsystem mit 2 bis 40 C-Atomen, welches substituiert oder auch unsubstituiert sein kann oder Ar-kond; die möglichen Substituenten R1 können dabei potentiell an jeder freien Position sitzen;
- m, n: sind gleich oder verschieden bei jedem Auftreten 0,1, oder 2;
- R1: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R2, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R1 substituiert sein können, oder Cl, F, CN, N(R2)₂, B(R2)₂, wobei auch zwei oder mehrere Reste R1 miteinander ein Ringsystem bilden können;
- R2: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R1 substituiert sein können,
mit der Maßgabe, das die Einheiten gemäß den Strukturen (1) bis (3) 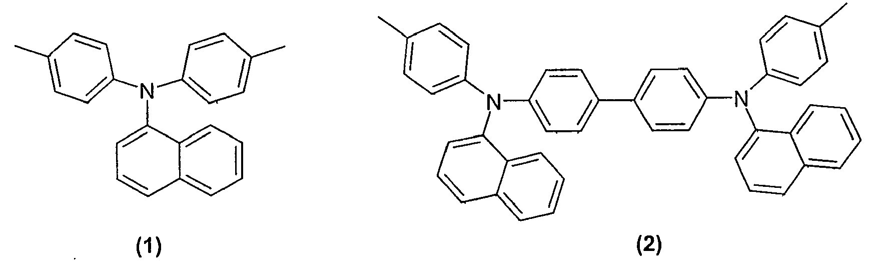 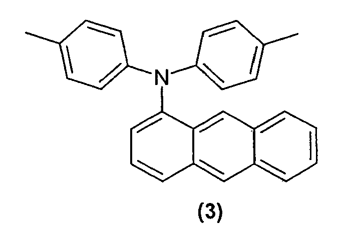 ausgenommen sind, wenn das konjugierte Polymer Metallkomplexe enthält welche einen Transfer von Singulett-Excitonen zu Triplett-Excitonen ermöglichen.

Konjugierte Polymere im Sinne dieser Erfindung sollen Polymere sein, die in der Hauptkette hauptsächlich sp²-hybridisierte Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette. Hauptsächlich meint, daß natürlich auftretende Defekte, die zu Konjugationsunterbrechungen führen, den Begriff "Konjugierte Polymere" nicht entwerten. Es sind jedoch keine Polymere, welche absichtlich eingefügte größere Mengen an nichtkonjugierten Segmenten enthalten, gemeint. Des weiteren wird in diesem Anmeldetext ebenfalls als konjugiert bezeichnet, wenn sich in der Hauptkette beispielsweise Arylamineinheiten gemäß Formel (1) oder andere derartige Einheiten und/oder bestimmte Heterocyclen (d. h. Konjugation über N-, O-, oder S-Atome) und/oder Metallorganische Komplexe (d. h. Konjugation über das Metallatom) befinden. Hingegen würden Einheiten wie beispielsweise einfache (Thio)Etherbrücken, Esterverknüpfungen, Amid- oder Imidverknüpfungen eindeutig als nicht-konjugierte Segmente definiert.

Die erfindungsgemäßen Polymere können nun neben den Einheiten gemäß Formel (I) noch weitere Strukturelemente enthalten. Dies sind u. a. solche, wie sie in den o. g. Patentanmeldungen bereits offenbart sind. Hier sei vor allem auch auf die relativ umfangreiche Auflistung in der oben schon erwähnten Anmeldeschrift WO 02/077060 verwiesen; diese wird via Zitat als Bestandteil der vorliegenden Erfindung betrachtet. Diese weiteren Struktureinheiten können beispielsweise aus den im folgenden beschriebenen Klassen stammen:
1. Struktureinheiten, die das Polymergrundgerüst bilden können, bzw. BLAU emittierende Einheiten:
   - Hier sind zunächst Poly-phenylene und davon abgeleitete Strukturen bildende Einheiten zu nennen. Dies sind beispielsweise (jeweils substituierte oder unsubstituierte) meta- oder para-Phenylene, 1,4-Naphthylene, 9,10-Anthracenylene, 2,7-Phenanthrenylene, 1,6- bzw. 2,7- bzw. 4,9-Pyrenylene oder 2,7-Tetrahydropyrenylene. Auch entsprechende heterocyclische "Poly-phenylene"-bildende Strukturen, wie beispielsweise Oxadiazolylen, 2,5-Thiophenylen, 2,5-Pyrrolylen, 2,5-Furanylen, 2,5-Pyridylen, 2,5-Pyrimidinylen, 3,6- bzw. 2,7-Carbazolylen oder 5,8-Chinolinylen kommen in Frage.
   - Des weiteren sind komplexere Einheiten, wie die o. g. Fluorene, Spiro-9,9'-bifluorene, mehrfach überbrückte Einheiten (z. B. kurze Teilsegmente der o. g. LPPP-Polymere), aber auch "doppelte Fluoren"-Einheiten (Indenofluorene) möglich. Auch diese können substituiert bzw. unsubstituiert sein.
2. Struktureinheiten, die beispielsweise die Farbe der Emission verschieben, damit auch die Bandlücke des Polymers verändern und somit i. d. R. auch die Ladungsinjektions- bzw. -transporteigenschaften verändern:
   - Hier sind beispielsweise weitere heterocyclische Verbindungen, wie die in der o. g. Anmeldung WO 02/077060 unter den Formeln (XX) bis (XXXXV) genannten Strukturen zu nennen.
   - Des weiteren sind hier aber auch Arylen-vinylen- oder Arylen-acetylen-strukturen, wie substituierte oder unsubstituierte Stilbenylene, Tolanylene, Bisstyrylarylene, Bis(arylacetylen)-arylene zu nennen.
   - Schließlich kann auch der Einbau von größeren aromatischen Einheiten, wie zum Beispiel Chrysenen, Naphthacenen, Pentacenen, Perylenen oder Coronenen, den o. g. Effekt (Farbverschiebung) erzeugen.
3. Struktureinheiten, welche einen Transfer von sogenannten Singulett-Excitonen zu Triplett-Excitonen ermöglichen, und welche auch bei Raumtemperatur mit hoher Effizienz aus dem Triplettzustand Licht emittieren können:
   - Hier sind nun zunächst vor allem Verbindungen, welche Schweratome, d. h. Atome aus dem Periodensystem der Elemente mit einer Ordnungszahl von mehr als 36, enthalten, zu verstehen.
   - Besonders geeignet hierfür sind Verbindungen, welche d- und f-Übergangsmetalle, die die o. g. Bedingung erfüllen, enthalten, zu sein. Ganz besonders bevorzugt scheinen hier entsprechende Struktureinheiten, welche Elemente der 8 bis 10 Gruppe (d. h. Ru, Os, Rh, lr, Pd, Pt) enthalten.
   - Als Struktureinheiten für die erfindungsgemäßen Polymeren kommen hier nun z. B. verschiedene Komplexe, welche beispielsweise in den Anmeldeschriften WO 02/068435, DE 10116962, EP 1239526 und der nicht offengelegten Anmeldeschrift DE 10238903.9 beschrieben sind, in Frage.
   - Für Polymere gemäß diesen hier beschriebenen Struktureinheiten gibt es in EP-A-1245659 eine zufällige Offenbarung an sich erfindungsgemäßer Einheiten, die dort aber ohne besondere Vorteile erwähnt werden. Demzufolge sind Polymere enthaltend Metallkomplexe und Einheiten gemäß den Strukturen (1) bis (3) von der Erfindung ausgenommen:

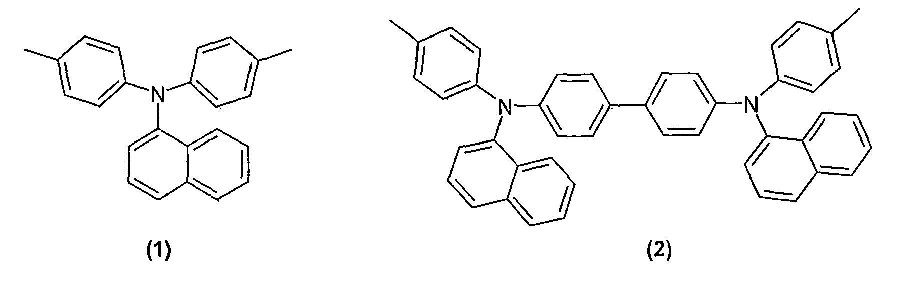

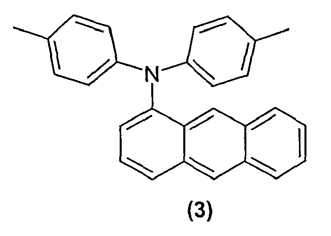

Eine Auswahl bevorzugter weiterer Einheiten der erfindungsgemäßen Polymere sind in der folgenden Übersicht aufgelistet:

| | | |
|---|---|---|
| 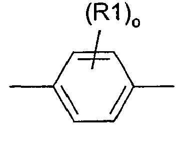 | 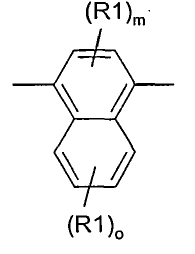 | 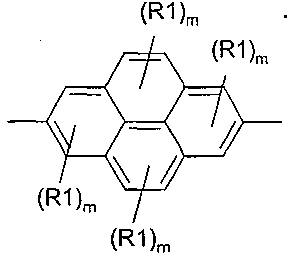 |
| 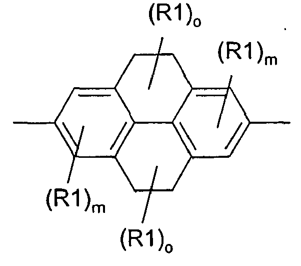 | 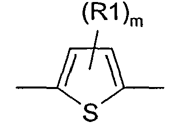 | 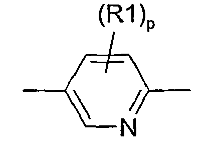 |
| 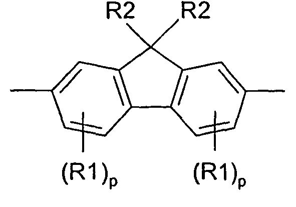 | 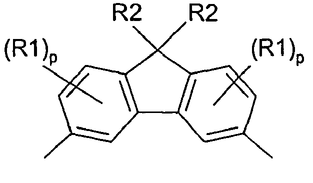 | 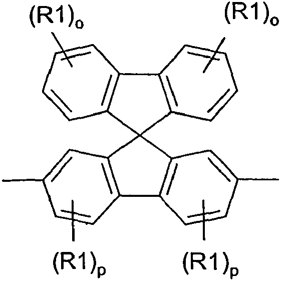 |
| 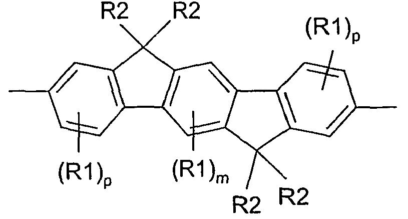 | | 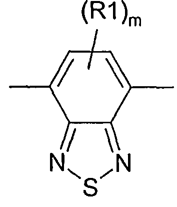 |
| 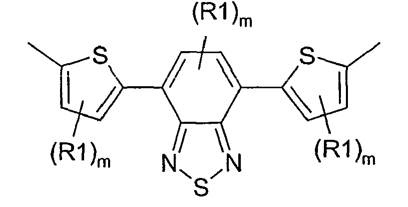 | | 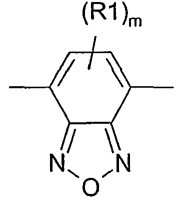 |
| 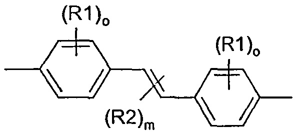 | 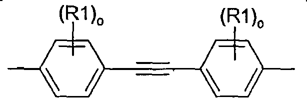 | 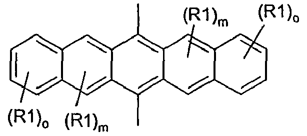 |
| 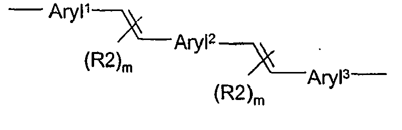 | | 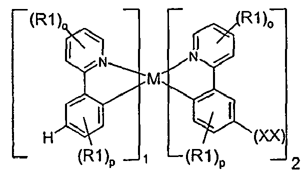 |
| 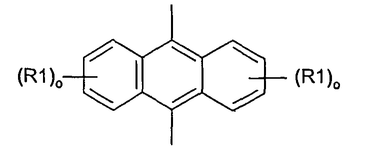 | | |

Die dabei verwendeten Symbole R1, R2, Aryl¹, Aryl², Aryl³, und Indizes m und n sind analog dem oben bereits beschriebenen zu verstehen.
- o: ist bei jedem Auftreten gleich oder verschieden 0, 1, 2, 3 oder 4;
- p: ist bei jedem Auftreten gleich oder verschieden 0, 1, 2 oder 3;
- M: ist bei jedem Auftreten gleich oder verschieden Rh oder Ir;
- (XX): soll die Verknüpfung im Polymer symbolisieren.
Die Einfachbindung stellt dabei die Verknüpfung im Polymer dar; sie soll hier keine Methylgruppe symbolisieren.

Die erfindungsgemäßen Polymere sind entweder Homopolymere, d. h. sie enthalten dann nur eine Struktur der Formel (1), oder sie sind Copolymere. Hierbei kann es bevorzugt sein, daß diese entweder mehrere verschiedene Struktureinheiten gemäß Formel (1) enthalten, oder neben einer oder mehrerer Struktureinheit(en) gemäß Formel (1) eine oder mehrere der oben beschriebenen bzw. aufgezählten Struktureinheiten enthalten.
Die erfindungsgemäßen Copolymeren können nun statistische, alternierende oder auch blockartige Strukturen aufweisen, oder auch mehrere dieser Strukturen abwechselnd besitzen. Durch das Verwenden mehrerer verschiedener Strukturelemente können Eigenschaften wie Löslichkeit, Festphasenmorphologie, Farbe etc. eingestellt werden.

Wie oben beschrieben, enthalten besonders bevorzugte erfindungsgemäße Polymere mindestens 10mol% Struktureinheiten gemäß Formel (I). Gerade für die Anwendung in den genannten PLEDs als emittierendes Material hat sich ein Anteil in dieser Größenordnung als günstig erwiesen. Für andere Anwendungen, z. B. als Ladungstransportschicht in Organischen Feld-Effekt-Transistoren (OFETs), kann sich auch ein deutlich höherer Anteil (bis zu 100mol%) als günstig erweisen.

Für bevorzugte Strukturen gemäß Formel (I) gilt folgendes:
- Ar¹, Ar², Ar³, Ar⁴: sind bei jedem Auftreten gleich oder verschieden einem aromatischen oder heteroaromatischen Ringsystem, ausgewählt aus Thiophen, Benzol, Pyridin, Fluoren, Spirobifluoren, Anthracen, oder Naphthalin, welche an den freien Positionen 0 bis 2 Substituenten R1 tragen;
- Ar-kond: ist bei jedem Auftreten gleich oder verschieden einem aromatischen oder heteroaromatischen Ringsystem, ausgewählt aus Naphthalin, Chinolin, Anthracen, Phenanthren oder Pyren, welche an den freien Positionen 0 bis 2 Substituenten R1 tragen;
- Ar⁵: ist bei jedem Auftreten gleich oder verschieden einem aromatischen oder heteroaromatischen Ringsystem, ausgewählt aus Benzol, Naphthalin, Chinolin, Anthracen, Phenanthren oder Pyren, welche an den freien Positionen 0 bis 2 Substituenten R1 tragen;
- m, R1, R2: sind analog den oben gemachten Angaben.

Für besonders bevorzugte Strukturen gemäß Formel (I) gilt folgendes:
- Ar¹, Ar², Ar³, Ar⁴: sind bei jedem Auftreten gleich oder verschieden Benzol, Fluoren, Anthracen, oder Naphthalin, welche keine Substituenten tragen bzw. das Fluoren nur an der 9 und 9' substituiert ist;
- Ar-kond: ist bei jedem Auftreten gleich oder verschieden Naphthalin, Anthracen oder Phenanthren, welche an den freien Positionen 1 oder 2 Substituenten R1 tragen;
- Ar⁵: ist bei jedem Auftreten gleich oder verschieden Naphthalin, Anthracen oder Phenanthren, welche an den freien Positionen 1 oder 2 Substituenten R1 tragen;
- m, R1, R2: sind analog den oben gemachten Angaben.

Ganz besonders bevorzugte Strukturen gemäß Formel (I) sind substituierte oder unsubstituierte Strukturen gemäß den abgebildeten Formeln (II) bis (XXXIV), wobei wegen der besseren Übersichtlichkeit potentielle Substituenten meistens nicht abgebildet sind:

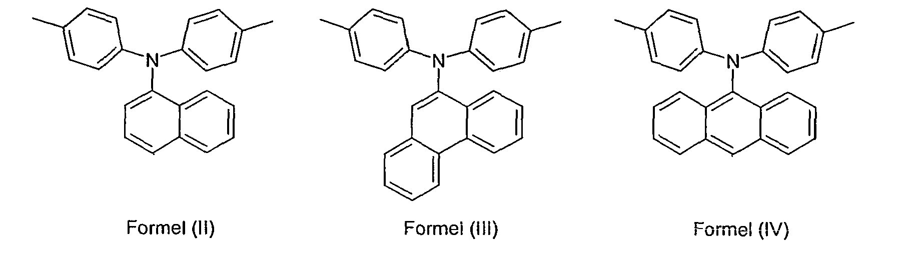

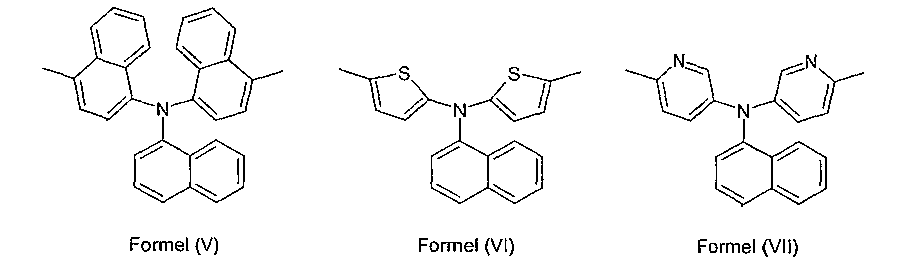

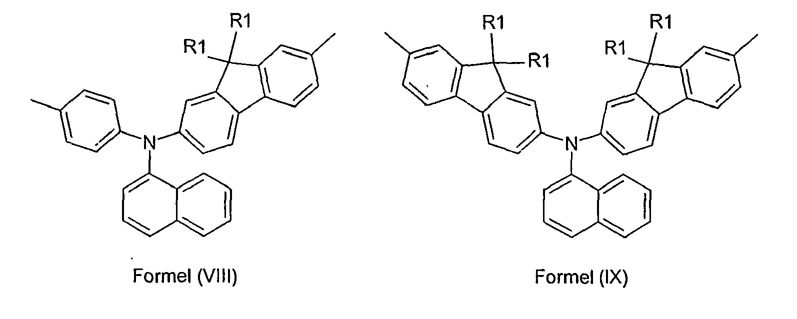

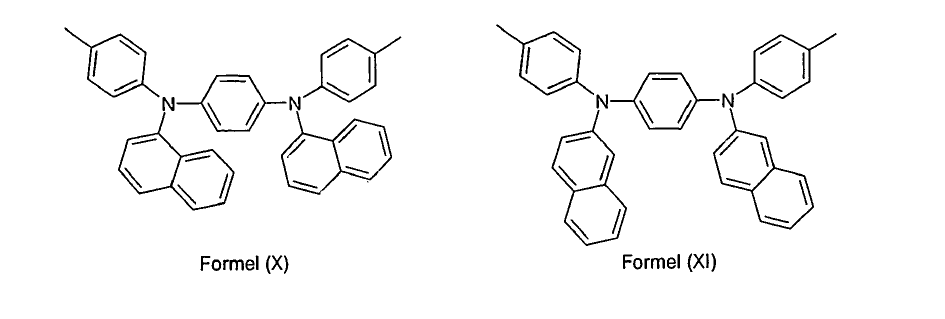

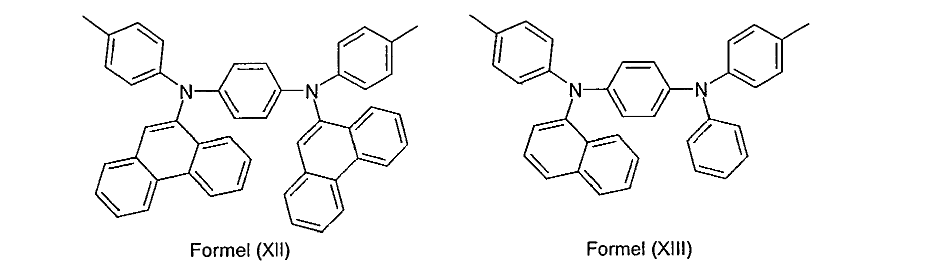

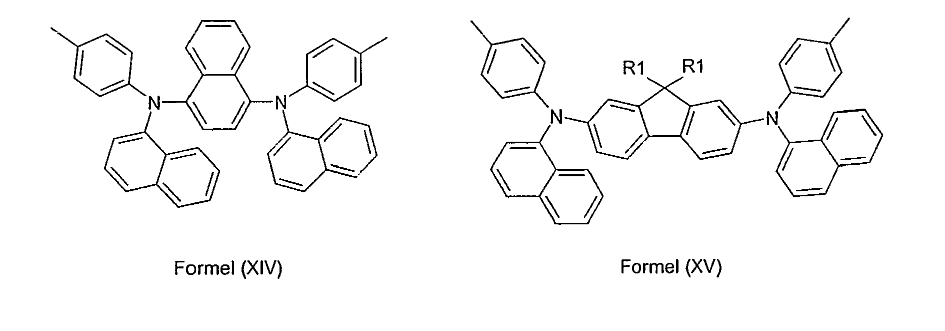

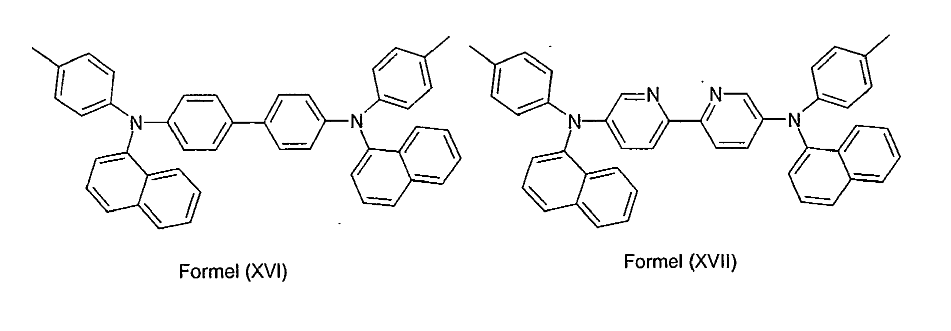

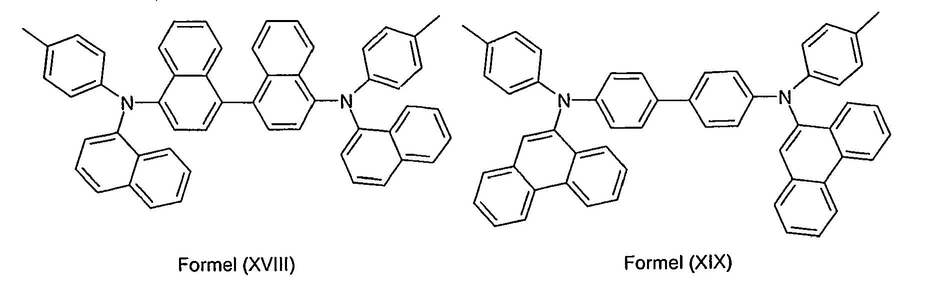

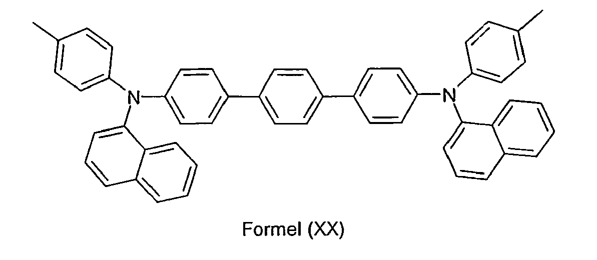

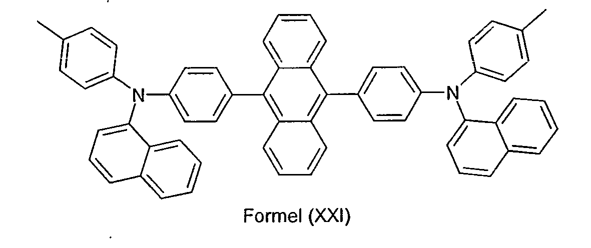

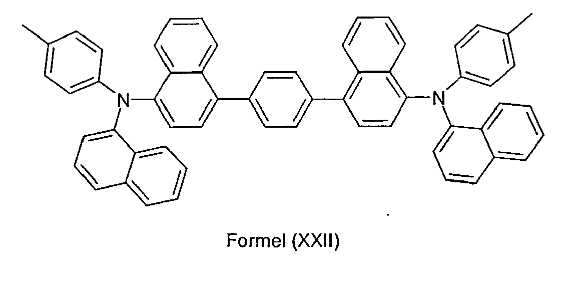

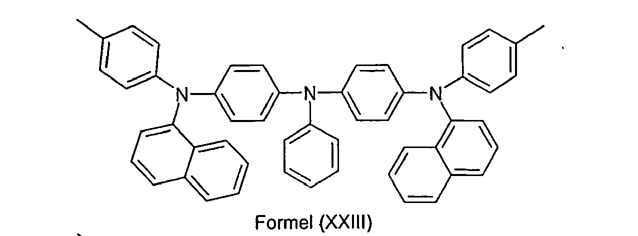

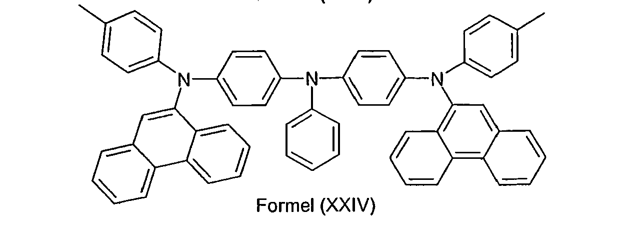

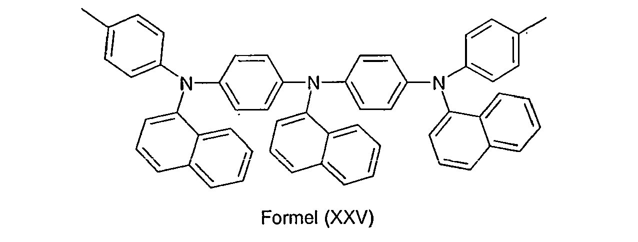

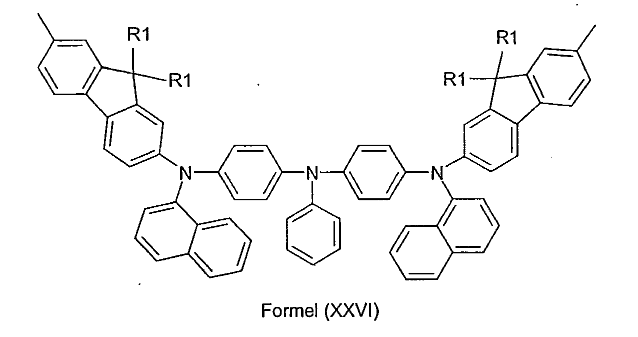

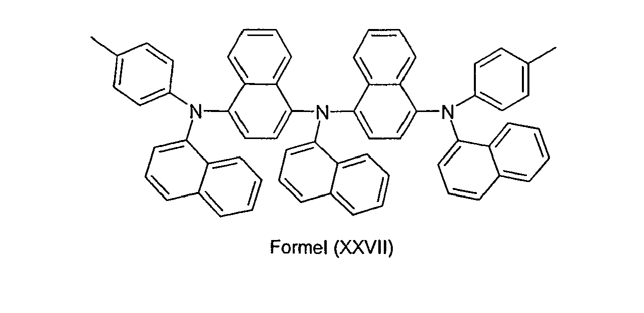

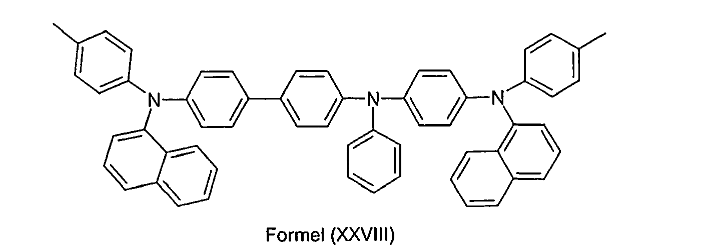

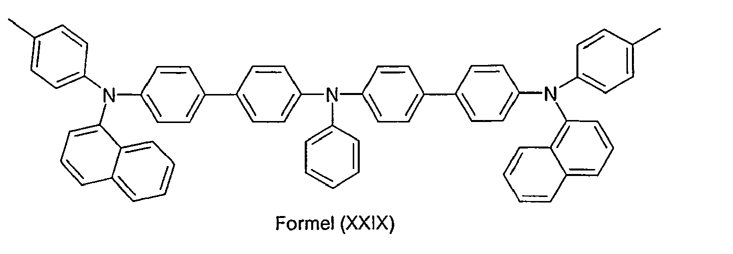

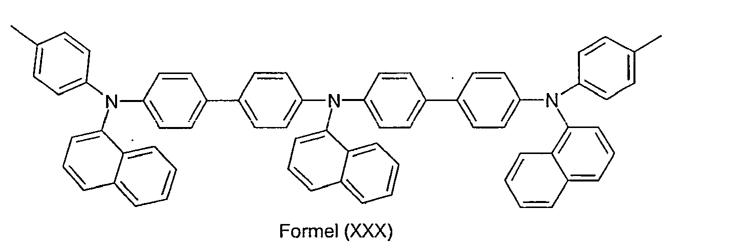

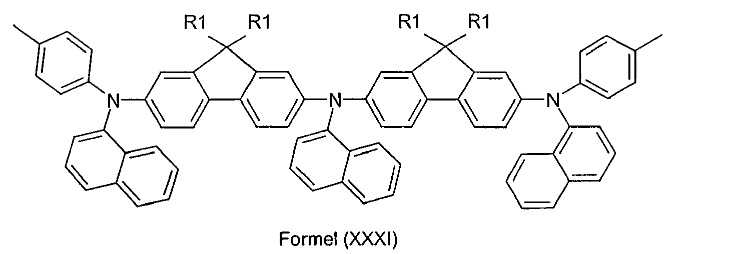

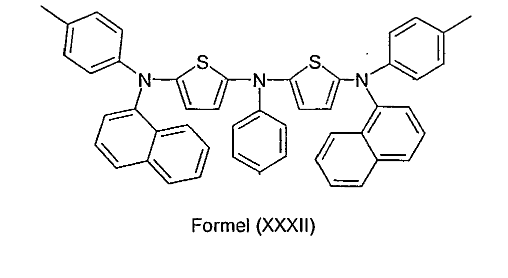

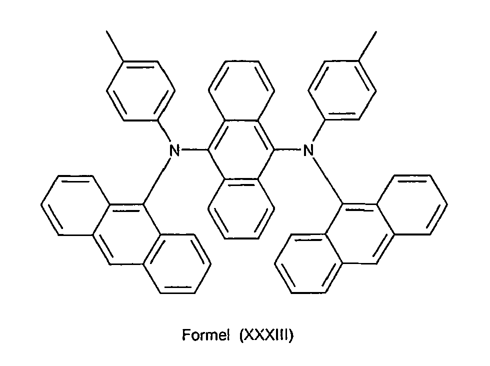

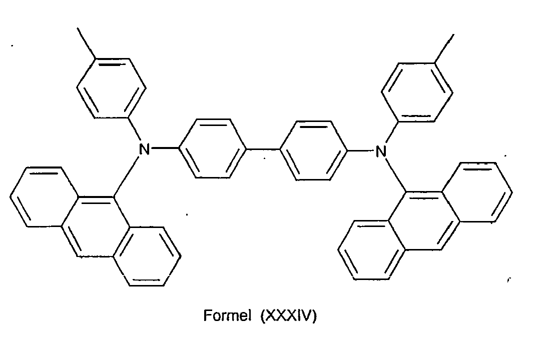

Für ganz besonders bevorzugte Strukturen gemäß Formel (I) gilt folgendes:
- Ar¹, Ar², Ar³, Ar⁴: sind bei jedem Auftreten gleich oder verschieden Benzol oder Fluoren, welche keine Substituenten tragen bzw. das Fluoren nur an der 9 und 9' substituiert ist;
- Ar-kond: ist bei jedem Auftreten gleich oder verschieden Naphthalin, Anthracen oder Phenanthren, welche an den freien Positionen 1 oder 2 Substituenten R1 tragen;
- Ar⁵: ist bei jedem Auftreten gleich dem in derselben Einheit vorhandenen Ar-kond;
- n: ist gleich oder verschieden bei jedem Auftreten 0 oder 1;
- m, R1, R2: sind analog den oben gemachten Angaben.

Auch wenn dies aus der Beschreibung hervorgeht, sei hier noch mal explizit darauf verwiesen, daß sowohl die Struktureinheiten gemäß Formel (I), als auch jene gemäß den Formeln (II) bis (XXXIV) unsymmetrisch substituiert sein können, d. h. an einer Einheit unterschiedliche Substituenten R1 vorhanden sein können, bzw. diese auch an unterschiedlichen Positionen angebunden sein können.

Die erfindungsgemäßen Polymere weisen in der Regel 10 bis 10000, bevorzugt 50 bis 5000, besonders bevorzugt 50 bis 2000 Wiederholeinheiten auf.

Die nötige Löslichkeit wird v. a. durch die Substituenten R1, sowohl an Strukturen gemäß Formel (I), als auch an solchen, die wie oben geschildert, in entsprechenden Copolymeren noch zusätzlich vorhanden sind, erreicht.
In der Regel ist es deshalb nötig, daß im Durchschnitt pro Wiederholeinheit mindestens 2 nicht-aromatische C-Atome in den Substituenten vorhanden sind. Bevorzugt sind dabei mindestens 4, besonders bevorzugt mindestens 8 C-Atome. Einzelne dieser C-Atome können auch noch durch O oder S ersetzt sein. Dies schließt nicht aus, daß ein gewisser Anteil von Wiederholeinheiten, sowohl solche gemäß Formel (I) als auch anderer Strukturtypen, keine weiteren nicht-aromatischen Substituenten tragen.
Um die Morphologie des Filmes nicht zu verschlechtern, ist es bevorzugt, keine langkettigen Substituenten mit mehr als 12 C-Atomen in einer linearen Kette zu haben, bevorzugt keine mit mehr als 8 C-Atome, besonders bevorzugt keine mit mehr als 6 C-Atome.
Nicht-aromatische C-Atome sind, wie in der Beschreibung für R1, in entsprechenden geradkettigen, verzweigten oder cyclischen Alkyl- oder Alkoxyketten enthalten.

Bevorzugt sind deshalb weiterhin erfindungsgemäße Polymere, bei denen gilt:
- R1: ist bei jedem Auftreten gleich oder verschieden eine geradkettige, verzweigte oder cyclische Alkyl- oder Alkoxykette mit 1 bis 10 C-Atomen, wobei auch ein oder mehrere H-Atome durch Fluor ersetzt sein können, eine Arylgruppe mit 6 bis 14 C-Atomen, welche auch durch ein oder mehrere nicht-aromatische Reste R1 substituiert ist.

Weiterhin besonders bevorzugt sind deshalb erfindungsgemäße Polymere, bei denen gilt:
- R1: ist bei jedem Auftreten gleich oder verschieden eine geradkettige oder verzweigte Alkyl- oder Alkoxykette mit 1 bis 8 C-Atomen, oder eine Arylgruppe mit 6 bis 10 C-Atomen, welche auch durch ein oder mehrere nicht-aromatische Reste R1 substituiert ist.

Die erfindungsgemäßen Polymere weisen nun gegenüber dem o. g. Stand der Technik u. a. folgende überraschende Vorteile auf:
- Die operative Lebensdauer bei der Verwendung in PLEDs ist bei vergleichbaren Polymeren erhöht (vgl. Angaben in Tabelle 1). Dies bringt für die Anwendung - wie oben bereits ausgeführt - deutliche Vorteile, da somit das Ziel, langlebige Vollfarbdisplays zu erzeugen, näher gerückt ist.
- Die Effizienz bei hohen Leuchtdichten kann bei vergleichbaren Polymeren deutlich erhöht werden, wenn diese Strukturelemente der Formel (I) enthalten. Dies ist u. a. den Angaben in Tabelle 2 zu entnehmen.
- Überraschend hat die Verwendung von erfindungsgemäßen Polymeren auch für die Erzeugung blauer Emission Vorteile: die Emissionsfarbe kann noch tiefer (d. h. tief-blau) werden, als diejenige bei analogen Polymeren ohne Struktureinheiten gemäß Formel (I). (vgl. Polymere P1 und P3 mit Polymer V1).
- Entsprechende Copolymere können so aufgebaut werden, daß diese alle Grundfarben (Rot, Grün, Blau) emittieren können. Dies ist zwar kein unmittelbarer Vorteil gegenüber Polymeren gemäß Stand der Technik; es ist jedoch wesentlich, dass diese Eigenschaft bei den erfindungsgemäßen Polymeren erhalten bleibt.
- Die Löslichkeit in organischen Lösemitteln ist i. d. R. gut, d. h. in Lösemitteln wie Toluol, Xylol, Anisol, Methylanisol, Methylnaphthalin sind die Polymere in Mengen im Bereich von 1 bis ca. 30 g/L (je nach Molekulargewicht) löslich.

Die erfindungsgemäßen Polymere werden nun in der Regel durch Polymerisation von einem oder mehreren Monomeren, von denen mindestens eines Strukturen der Formel (I) ergibt, hergestellt.
Entsprechende Polymerisationsreaktionen gibt es prinzipiell relativ viele verschiedene, es haben sich jedoch die im folgenden aufgeführten Typen besonders bewährt. Grundsätzlich ergeben die Reaktionstypen (A) bis (C) C-C-Verknüpfungen, Reaktionstyp (D) ergibt C-N-Verknüpfungen:
(A) Polymerisation gemäß SUZUKI: Hierbei werden als Monomere zum einen Bishalogenide, zum anderen Bisboronsäuren und entsprechende -derivate oder entsprechende Monohalogenid-monoboronsäurederivate eingesetzt und unter Palladiumkatalyse, in Anwesenheit von Lösemitteln und basischen Bedingungen gekuppelt. Derartige Reaktionen, welche zu konjugierten Polymeren führen, sind bereits vielfach beschrieben. Es gibt eine ganze Reihe von Vorschlägen, wie derartige Reaktionen effizient ablaufen und zu hochmolekularen Polymeren führen können; diese sind u. a. in den folgenden Stellen aufgeführt: (i) EP 707.020, (ii) EP 842.208, (iii) EP 1.025.142, (iv) WO 00/53656, (v) WO 03/048225 und (vi) in den darin zitierten Literaturstellen. Die entsprechenden Beschreibungen werden hiermit via Zitat als Bestandteil der Anmeldung erachtet.
(B) Polymerisationen gemäß YAMAMOTO: Hierbei werden als Monomere ausschließlich Bishalogenide verwendet. Diese werden in Anwesenheit von Lösemitteln, einer NickelVerbindung, und gegebenenfalls eines Reduktionsmittels sowie weiterer Liganden durchgeführt. Derartige Reaktionen, welche zu konjugierten Polymeren führen, sind bereits beschrieben. Es gibt einige Vorschläge, wie derartige Reaktionen effizient ablaufen und zu hochmolekularen Polymeren führen können; diese sind u. a. in den folgenden Stellen aufgeführt: (i) M. Ueda et al., *Macromolecules,* **1991**, 24, 2694, (ii) T. Yamamoto et al., *Macromolecules* **1992**, 25, 1214, (iii) T. Yamamoto et al., *Synth. Met*. **1995,** 69, 529-31, (iv) T. Yamamoto et al., *J. Organometallic Chem.* **1992,** 428, 223, (v) I. Colon et al., *J. Poly. Sci.: Part A*: *Poly. Chem.* **1990**, 28, 367, (vi) T. Yamamoto et al., *Macromol. Chem. Phys.* **1997**, 198, 341. (vii) Ein gut funktionierendes Verfahren ist auch in der noch nicht offengelegten Anmeldeschrift DE 10241814.4 beschrieben. Die entsprechenden Beschreibungen werden hiermit via Zitat als Bestandteil der Anmeldung erachtet.
(C) Polymerisationen gemäß STILLE: Hierbei werden als Monomere zum einen Bishalogenide, zum anderen Bisstannate oder entsprechende Monohalogenidmonostannate eingesetzt und unter Palladiumkatalyse, in Anwesenheit von Lösemitteln gekuppelt. Derartige Reaktionen, welche zu konjugierten Polymeren führen, sind bereits beschrieben. Es gibt hier allerdings noch nicht so weite Ausarbeitungen, wie dies im Falle der SUZUKI- oder YAMAMOTO-Kupplung der Fall ist. Ein konjugiertes Polymer, welches durch STILLE-Kupplung erhalten wurde, wird z. B. in W. Schorf et al., *J. Opt. Soc. Am. B* **1998,** 15, 889 beschrieben. Eine Übersicht über die Möglichkeiten und die Schwierigkeiten der STILLE-Reaktion gibt u. a. V. Farina, V. Krishnamurthy, W. J. Scott (Hers.) "**The Stille Reaction**" **1998**, Verlag: Wiley, New York, N. Y. Die entsprechenden Beschreibungen werden hiermit via Zitat als Bestandteil der Anmeldung erachtet.
(D) Polymerisationen gemäß HARTWIG / BUCHWALD bzw. der Beschreibung in WO 99/12888: Hierbei werden als Monomere zum einen Bishalogenide, zum anderen entsprechende Bisarylamine (welche noch mindestens ein H-Atom am Stickstoff aufweisen) oder entsprechende Monohalogenid-monoaminverbindungen eingesetzt und unter Palladium- bzw. Nickelkatalyse, in Anwesenheit von Lösemitteln, basischen Bedingungen und speziellen Liganden gekuppelt. Entsprechende Verfahren (zumindest für die niedermolekulare Variante, teilweise aber mit Beschreibung für die Erzeugung von Polymeren) sind u. a. in (i) US 5576460, (ii) EP 802173, (iii) WO 99/12888 beschrieben.

Die eigentliche Polymerisation (Polykondensation) (vgl. auch die Angaben bei den Beispielen) läuft nun allgemein dadurch ab, daß das/die Monomer(e) in einem geeigneten Konzentrationsbereich in Lösung mit den entsprechenden Katalysatoren und Hilfssystemen zur Reaktion gebracht werden. Dabei kann es vorteilhaft sein, durch geringe Abweichungen von der idealen Stöchiometrie, bzw. durch das Vorhandensein geringer Mengen monofunktioneller Verbindungen, eine Molekulargewichtsbegrenzung durchzuführen. Die Reaktion wird i. d. R. bis zum gewünschten Molekulargewicht durchgeführt (dabei kann beispielsweise Prozeßkontrolle über Viskositätsmessung erfolgen). Danach wird die Reaktion abgebrochen. Dies kann auf verschiedene Weise erfolgen. Es hat sich bewährt, um reaktive Endgruppen zu vermeiden, ein sogenanntes "End-capping" durchzuführen, d. h. nach Erreichen des gewünschten Molekulargewichts mono-funktionelle Verbindungen zuzugeben. Bei den Reaktionstypen A, C und D kann dies auch doppelt erfolgen, d. h. man gibt zuerst eine/mehrere monofunktionelle Verbindung(en) des einen Typs (z. B. Monohalogenid) und anschließend des anderen Typs (z. B. Monoboronsäurederivat) zu.

Danach müssen die synthetisierten Polymere zunächst vom Reaktionsmedium abgetrennt werden. Dies geschieht in der Regel durch Ausfällen in einem Nicht-Lösemittel. Anschließend müssen die erhaltenen Polymere aufgereinigt werden, da gerade der Gehalt an organischen niedermolekularen Verunreinigungen und auch der lonengehalt bzw. Gehalt an sonstigen anorganischen Verunreinigungen teilweise sehr starke Auswirkungen auf die Anwendungseigenschaften der Polymere in PLEDs oder auch anderen Applikationen haben. So können niedermolekulare Bestandteile zum einen die Effizienz erheblich absenken, aber auch die operative Lebensdauer dramatisch verschlechtern (z. B. durch Diffusion während des Betriebs). Analoges gilt für die Anwesenheit von anorganischen Verunreinigungen.
Geeignete Reinigungsverfahren sind zum einen Umfällvorgänge, bei denen das Polymer wiederholt gelöst und in einem Nicht-Lösemittel gefällt wird. Es ist dabei sinnvoll, die Polymerlösung über einen Filter zu geben, um von ungelösten Bestandteilen (vernetzte Gelpartikel) und auch Staubpartikeln abzutrennen. Eine weitere Möglichkeit ist das Verwenden von lonenaustauschern, um den Gehalt an Ionen zu verringern. Hierbei kann auch das Ausrühren einer Polymerlösung mit einer wässrigen Lösung, welche z. B. chelatisierende Liganden enthält, helfen. Auch weitere organische oder anorganische Extraktionsverfahren, z. B. mit Lösemittel / Nicht-Lösemittelgemischen oder mit überkritischem CO₂, können hier deutliche Verbesserungen bringen.

Um die entsprechenden erfindungsgemäßen Polymere beispielsweise durch die o. g. Verfahren herstellen zu können, benötigt man - wie beschrieben - die entsprechenden Monomere.
Für Strukturen gemäß Formel (I) können diese beispielsweise wie im folgenden beschrieben, erhalten werden:
- Entsprechende aromatische Tri(hetero)arylamine sind prinzipiell immer gemäß den oben bereits unter der Polymerisationsbeschreibung (Punkt D) und den darin zitierten Quellen darstellbar, d. h. ausgehend von einfacheren Aminen und entsprechenden Halogenaromaten sind damit komplexere Strukturen aufbaubar.
- Eine entsprechende Funktionalisierung, die eine Verwendung als Monomere ermöglicht (d. h. z. B. Halogen-endgruppen), kann nun entweder bereits vor der Herstellung der entsprechenden Verbindung gemäß Formel (I) an den Vorstufen erfolgen, bzw. als letzter Schritt an dem bereits vollständig aufgebauten Grundgerüst. Beide Varianten haben, je nach angestrebter Zielstruktur sowohl Vor- als auch Nachteile.
- Vorab können die Funktionalitäten bereits vorhanden sein, wenn diese bei der Kopplung zum entsprechenden Monomer gemäß Formel (I) entweder nicht, oder sehr erschwert reagieren. Dies kann z. B. der Fall sein, wenn man unterschiedliche Reaktivitäten (z. B. lod gegenüber Brom, bzw. Brom gegenüber Chlor) ausnutzen kann. So können beispielsweise Monomere für die Strukturformeln (II) bis (IX) unter Ausnutzung dieser Selektivität hergestellt werden, wie dies für ein einfaches Beispiel zu (II) im folgenden geschildert ist: Setzt man 4,4'-Dibrom-diphenylamin mit 1-lodnaphthalin unter ULLMANN-Bedingungen um (vgl. H. Kageyama et al., *J. Mater. Chem.* **1996,** 6, 675-676), erhält man in guten Reinheiten und Ausbeuten das entsprechende Bis-(4-bromphenyl)-naphthyl-amin.
- Analog können auch viele Monomere gemäß den Strukturformeln (X) bis (XXII) bzw. über mehrere Schritte auch (XXIII) bis (XXXIV) aufgebaut werden.
- Andererseits kann es aber auch vorteilhaft sein (bei z. B. vorliegender Substitution bzw. dirigierenden Resten), zunächst den Arylamingrundkörper aufzubauen und in einem letzten Schritt das Halogenid einzuführen. So ist es beispielsweise für Strukturen gemäß Formel (XVI) möglich, in die jeweiligen 4- und 4'-Positionen des Phenyls Brom einzuführen (durch milde NBS-Bromierung, vgl. z. B. Creason et al., *J. org. Chem,* **1972,** 37, 4440), wenn an den Naphthalinresten jeweils in 4-Stellung ein Substituent vorhanden ist. Wie oben geschildert, kann dieses Verfahren, beim Vorhandensein (i) entsprechender blockierender Substituenten, (ii) entsprechend dirigierender Reste, oder (iii) aktivierter bzw. deaktivierter Heterocyclen, auch für weitere Strukturen gemäß Formel (I) im allgemeinen und gemäß den Formeln (II) bis (XXXII) im speziellen, angewendet werden.
- Ausgehend von den so erzeugten Halogenid-derivaten können über Standardverfahren entsprechenden Bisboronsäurederivate bzw. Bisstannanderivate (die für die o. g. Polymerisationsverfahren der Typen A und C benötigt werden) hergestellt werden. Diese Verfahren sind dem Fachmann hinlänglich bekannt und bestehen i. d. R. darin, das vorhandene Halogen gegen ein Metall auszutauschen (z. B. Magnesium, Lithium) und dieses dann mit einer Boresterverbindung bzw. einer Trialkylzinnhalogenverbindung umzusetzen. Für die Herstellung von Boronsäurederivaten sind auch katalytische Verfahren zur direkten Umsetzung der Halogenide mit bspw. Diboranen bei Anwesenheit von Palladium bekannt. Entsprechende Monohalogenidmonoboronsäurederivat- bzw. Monohalogenid-monostannat-Verbindungen sind bei geeigneter Stöchiometrie auch erhältlich.
- Für Umsetzungen gemäß Polymerisationtyp (D) benötigt ein Teil der Monomere keine Halogen-Funktionalität, sondern eben nur sekundäre Amin-Funktionalitäten. Diese sind über die o. g. Synthesemethoden einfach zu erhalten.
   Die Synthese der weiteren Monomere, welche zu Strukturen führen, die nicht denen der Formel (1) entsprechen, die aber oben beschrieben wurden, ist in den bereits oben genannten Anmeldeschriften und Patenten ausführlich beschrieben.
   Einen guten Überblick hierzu gibt dabei die Anmeldeschrift WO 02/077060, die dort gemachten entsprechenden Ausführungen werden via Zitat als Bestandteil dieser Anmeldung betrachtet.

Die so erhaltenen erfindungsgemäßen Polymere können nun in PLEDs verwendet werden. Dazu wird in der Regel folgendes allgemeine Verfahren verwendet, das entsprechend dem Einzelfall anzupassen ist:
- Ein Substrat (z. B. Glas oder auch ein Kunststoff, wie speziell behandeltes PET) wird mit einem transparenten Anodenmaterial beschichtet (beispielsweise Indium-Zinn-Oxid, ITO); anschließend wird die Anode (z. B. photolithografisch) der gewünschten Anwendung gemäß strukturiert und verschaltet. Es kann hier auch sein, daß das ganze Substrat und die entsprechende Verschaltung zunächst über einen recht aufwendigen Prozeß erzeugt wird, um dadurch eine sogenannte Aktiv-Matrix-Steuerung zu ermöglichen.
- Anschließend wird entweder vollflächig, oder nur auf die aktiven (= anodischen) Stellen i. d. R. zunächst ein leitfähiges Polymer, z. B. ein dotiertes Polythiophen-oder Polyanilinderivat, aufgebracht. Dies erfolgt in aller Regel durch Beschichtungsverfahren, welche eine Dispersion des entsprechenden Polymers aufbringen. Hierzu eignen sich prinzipiell die weiter unten für das lichtemittierende Polymer beschriebenen Verfahren. Die Schichtdicke dieser Polymerlage kann in weiten Bereichen variieren, wird aber für die praktische Anwendung im Bereich zwischen 10 und 1000 nm, bevorzugt zwischen 20 und 500 nm liegen.
- Darauf bringt man dann, je nach Anwendung, eine Lösung eines erfindungsgemäßen Polymers auf. Für mehr- oder vollfarbige Anzeigeelemente (Displays) werden dann mehrere verschiedene Lösungen in verschiedenen Regionen aufgebracht, um entsprechende Farben zu erzeugen.
   Die erfindungsgemäßen Polymeren werden dazu zunächst einzeln (es kann auch empfehlenswert sein, Blends von zwei oder mehr Polymeren zu verwenden) in einem Lösemittel oder Lösemittelgemisch gelöst und schließlich filtriert. Da die organischen Polymere und v. a. die Zwischenschichten (Interface) in der PLED teilweise extrem durch Sauerstoff oder andere Luftbestandteile beeinflußt werden, empfiehlt es sich, diese Operation unter Schutzgas durchzuführen. Als Lösemittel eignen sich aromatische Flüssigkeiten wie beispielsweise Toluol, Xylole, Anisol, Chlorbenzol, aber auch andere, wie beispielsweise cyclische Ether (z. B. Dioxan, Methyldioxan) oder auch Amide, wie beispielsweise NMP oder DMF, aber auch Lösemittelgemische, wie diese in der Anmeldeschrift WO 02/072714 beschrieben werden.
   Mit diesen Lösungen können nun die vorher beschriebenen Träger beschichtet werden, und zwar entweder ganzflächig z. B. durch Spin-Coat-Verfahren oder Rackel-Techniken, oder aber auch ortsaufgelöst durch Druckverfahren, wie Tintenstrahldrucken, Off-Set-Drucken, Screen-Printing-Verfahren, Tiefdruckverfahren und ähnlichen.
- Auf diese Polymerschichten können nun optional weitere Elektroneninjektionsmaterialien aufgebracht werden, z. B. durch Aufdampfen, oder auch aus Lösung, durch Methoden, wie diese für die emittierenden Polymere beschrieben wurden. Als Elektroneninjektionsmaterialien können beispielsweise niedermolekulare Verbindungen, wie Triarylboranverbindungen oder auch Aluminiumtrishydroxychinolinat (Alq₃), aber auch entsprechende Polymere, wie beispielsweise Poly-pyridinderivate und ähnliche, verwendet werden. Es ist auch möglich, dünne Schichten des emittierenden Polymers durch entsprechendes Dotieren in Elektroneninjektionsschichten umzuwandeln.
- Daran anschließend wird eine Kathode aufgedampft. Dies erfolgt i. d. R. durch einen Vakuumprozeß und kann beispielsweise sowohl durch thermisches Bedampfen als auch durch Plasmaspritzen (Sputtern) geschehen. Die Kathode kann dabei vollflächig oder auch durch eine Maske strukturiert aufgebracht werden. Als Kathode werden i. d. R. Metalle mit geringer Austrittsarbeit, z. B. Alkali-, Erdalkali- und f-Übergangsmetalle, wie z. B. Li, Ca, Mg, Sr, Ba, Yb, Sm oder auch Aluminium, oder auch Legierungen von Metallen, oder auch mehrlagige Strukturen mit verschiedenen Metallen verwendet. Bei letzterem können auch Metalle mitverwendet werden, die eine relativ hohe Austrittsarbeit aufweisen, wie z. B. Ag. Es kann auch bevorzugt sein, zwischen das Metall und das emittierende Polymer bzw. die Elektroneninjektionsschicht, eine sehr dünne dielektrische Schicht (z. B. LiF oder ähnliches) einzubringen. Die Kathoden sind i. d. R. zwischen 10 und 10000 nm, bevorzugt zwischen 20 und 1000 nm, dick.
- Anschließend werden die so erzeugten PLEDs bzw. Displays entsprechend angeschlossen und verkapselt, um dann getestet oder verwendet zu werden.

Wie oben beschrieben, eignen sich die erfindungsgemäßen Polymere ganz besonders als Elektroluminszenzmaterialien in den derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, daß die Schicht befähigt ist, bei Anlegen eines elektrischen Feldes Licht abzustrahlen (lichtemittierende Schicht), und/oder daß sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Transportschicht und/oder eine Ladungsinjektionsschicht sein.

PLEDs finden z.B. Anwendung als selbstleuchtende Anzeigeelemente, wie Kontrollampen, alphanumerische Displays, mehr- oder vollfarbigen Displays, Hinweisschilder, und in optoelektronischen Kopplern.

Im vorliegenden Anmeldetext und auch in den im weiteren folgenden Beispielen wird auf die Verwendung erfindungsgemäßer Polymere oder Blends aus erfindungsgemäßen Polymeren in Bezug auf PLEDs und den entsprechenden Displays abgezielt. Trotz dieser Beschränkung der Beschreibung ist es für den Fachmann ohne weiteres erfinderisches Zutun möglich, die erfindungsgemäßen Polymere auch für weitere Verwendungen in anderen elektronischen Devices (Vorrichtungen) zu benutzen, z. B. für Organische Integrierte Schaltungen (O-ICs), in Organischen Feld-Effekt-Transistoren (OFETs), in Organischen Dünnfilmtransistoren (OTFTs), für Organische Solarzellen (O-SCs) oder auch Organische Laserdioden (O-Laser), um nur einige Anwendungen zu nennen. Gerade für O-ICs und OFETs können entsprechende erfindungsgemäße Polymere, welche einen relativ hohen Anteil an Strukturelementen gemäß Formel (I) besitzen (bevorzugt einen Anteil von mehr als 20%), Verwendung finden.

Die Erfindung wird durch die nachfolgenden Beispiele näher erläutert, ohne sie dadurch einschränken zu wollen.

### Beispiele

### Teil A: Synthese der Monomere:

### A1: Monomere für Einheiten gemäß Formel (1)

### A1.1 Synthese von erfindungsgemäßem Monomer 1 (EM 1)

### Herstellung von 4-Brom-1-(pentamethylphenyl)-naphthalin

Zu einer Lösung von 25 g (91 mmol) 1-Pentamethylphenylnaphthalin in 500 ml CHCl₃ wurden bei einer Temperatur von 5°C 10 ml (100 mmol) Br₂ innerhalb 15 min getropft und das Reaktionsgemisch für 6 h bei RT gerührt. Anschließend wurden 100 ml ges. Na₂SO₃-Lsg. zugegeben, die org. Phase abgetrennt, mit NaHCO₃-Lsg gewaschen und über Na₂SO₄ getrocknet. Der nach Entfernen des Lösungsmittels verbleibende Feststoff wurde aus n-Heptan umkristallisiert. Man erhielt 27.3 g (85%) farbloser Kristalle.
¹H-NMR (d₆-DMSO): [ppm] = 8.21 (d, ³J_{HH} = 8.4 Hz, 1 H), 7.95 (d, ³J_{HH} = 7.7 Hz, 1 H), 7.68 (t, ³J_{HH} = 6.7 Hz, 1 H), 7.51 (t, ³J_{HH} = 6.7 Hz, 1 H), 7.24 (d, ³J_{HH} = 8.0 Hz), 7.1 (d, ³J_{HH} = 7.7 Hz), 2.28 (s, 3 h), 2.21 (s, 6 H), 1.69 (s, 6 H).

### Herstellung von N,N'-Diphenyl-N,N'-bis-1-(4-pentamethylphenyl)naphthylbiphenyl-4,4'-diamin

Zu einer mit N₂ gesättigten Lösung von N,N'-Diphenylbenzidin (13 g, 39 mmol) und 29 g (82 mmol) 4-Brom-1-(pentamethylphenyl)-naphthalin in 175 ml trockenem Toluol wurden nacheinander im Ar-Gegenstrom 90 mg (0.4 mmol) Pd(OAc)₂, 165 mg (0.8 mmol) P(^{t}Bu)₃ und 11.05 g (115 mmol) NaO^{t}Bu zugegeben und anschließend für 2 h zum Rückfluss erhitzt. Nach dieser Zeit wurde der Ansatz auf RT abgekühlt und 20 ml 1%ige NaCN-Lsg. zugetropft, weitere 4 h gerührt und der entstandene Niederschlag abgesaugt, mit H₂O und MeOH gewaschen, getrocknet und dreimal aus Chlorbenzol umkristallisiert. Es verblieben 18.2 g (53%) des Produktes in Form eines weißen Pulvers mit einer Reinheit von 99.8% (HPLC).
¹H-NMR (CDCl₃): [ppm] = 7.96 (d, ³J_{HH} = 8.0 Hz, 2 H), 7.52 (d, ³J_{HH} = 8.7 Hz, 4 H), 7.45 (d, ³J_{HH} = 7.4 Hz, 2 H), 7.38 (m, 4 H), 7.27 (m, 8 H), 7.01 (m, 10 H), 2.29 (s, 6 H), 2.23 (s, 12 H), 1.78 (s, 12 H).

### Herstellung von N,N'-Bis-(4-bromphenyl)-N,N'-bis-1-(4-pentamethylphenyl)naphthyl-biphenyl-4,4'-diamin (EM 1)

16.3 g (18.5 mmol) N,N'-Diphenyl-N,N'-bis-1-(4-pentamethylphenyl)naphthyl-biphenyl-4,4'-diamin wurden in 150 ml CHCl₃ gelöst und unter Luft- und Wasserausschluss bei 0 °C mit 7.3 g NBS (41 mmol) und 92 mg (0.6 mmol) wasserfreiem FeCl₃ versetzt. Nach 5 min wurde die Reaktion mit 20 ml MeOH gestoppt und die Suspension filtriert, der Rückstand mit Wasser und MeOH ausgerührt und der farblose Fetstoff viermal aus Toluol umkristallisiert. Man erhielt das Bisbromid als farbloses Pulver (13 g, 68%) mit einer Reinheit >99.8% (HPLC).
¹H-NMR (d₆-DMSO): [ppm] = 7.93 (d, ³J_{HH} = 8.0 Hz, 2 H), 7.55 (d, ³J_{HH} = 8.7 Hz, 4 H), 7.42 (m, 10 H), 7.26 (t, ³J_{HH} = 6.0 Hz, 4 H), 7.07 (d, ³J_{HH} = 8.7 Hz, 4 H), 6.92 (d, ³J_{HH} = 9.0 Hz, 4 H), 2.29 (s, 6 H), 2.26 (s, 12 H), 1.77 (s, 12 H).

### A1.2 Synthese von erfindungsgemäßem Monomer 2 (EM 2)

### Herstellung von N,N'-Diphenyl-N,N'-bis(4-methylnaphthyl)-biphenyl-4,4'-diamin

Zu einer mit N₂ gesättigten Lösung von N,N'-Diphenylbenzidin (11.5 g, 34.3 mmol) und 15.5 g (69 mmol) 4-Brommethylnaphthalin in 150 ml trockenem Toluol wurden nacheinander im Ar-Gegenstrom 78 mg (0.35 mmol) Pd(OAc)₂, 137 mg (0.68 mmol) P(*^{t}*Bu)₃ und 9.28 g (96.5 mmol) NaO*^{t}*Bu zugegeben und anschließend für 2 h zum Rückfluss erhitzt. Nach dieser Zeit wurde der Ansatz auf RT abgekühlt und 15 ml 1 %ige NaCN-Lsg. zugetropft, weitere 4 h gerührt und der entstandene Niederschlag abgesaugt, mit H₂O und MeOH gewaschen, getrocknet und zweimal aus Toluol umkristallisiert. Es verblieben 18.6 g (88%) des Produktes in Form eines farblosen Pulvers mit einer Reinheit von 99.6% (HPLC).
¹H-NMR (CDCl₃): [ppm] = 8.0 (2 d, ³J_{HH} = 8.4 Hz, ³J_{HH} = 8.7 Hz, 4 H), 7.49 (t, ³J_{HH} = 7.7 Hz, 4 H), 7.35 (m, 8 H), 7.23 (m, 2 H), 7.18 (t, ³J_{HH} = 8.0 Hz, 4 H), 7.04 (t, ³J_{HH} = 9.0 Hz, 8 H), 6.9 (t, ³J_{HH} = 7.3 Hz, 2 H), 2.71 (s, 6 H).

### Herstellung von N,N'-Bis-(4-bromphenyl)-N,N'-bis(4-methylnaphthyl)-biphenyl-4,4'-diamin (EM 2)

15.8 g (25.6 mmol) N,N'-Diphenyl-N,N'-bis(4-methylnaphthyl)-biphenyl-4,4'-diamin wurden in 200 ml CHCl₃ gelöst und bei 0 °C unter Wasser- und Luftausschluss 9.4 g (51.2 mmol) NBS sowie 132 mg (0.9 mmol) FeCl₃zugegeben. Nach 5 min wurde die Reaktion durch Zugabe von 50 ml MeOH gestoppt, der Niederschlag abgesaugt, mit H₂O und MeOH gewaschen und fünfmal aus Toluol umkristallisiert. Man erhielt 14 g (71%) eines farblosen Pulvers, das nach HPLC einen Gehalt von 99.9% aufwies.
¹H-NMR (d₆-DMSO): [ppm] = 8.08 (d, ³J_{HH} = 8.4 Hz, 2 H), 7.86 (³J_{HH} = 8.4 Hz, 2 H), 7.57 (t, ³J_{HH} = 7.7 Hz, 2 H), 7.45 (m, 8 H), 7.35 (d, ³J_{HH} = 8.7 Hz, 4 H), 7.30 (³J_{HH} = 7.4 Hz, 2 H), 7.05 (d, ³J_{HH} = 8.7 Hz, 4 H), 6.83 (³J_{HH} = 8.7 Hz, 4 H), 2,68 (s, 6 H).

### A1.3 Synthese von erfindungsgemäßem Monomer 3 (EM 3)

Herstellung von N,N'-Diphenyl-N,N'-bis(4-methylnaphthyl)-anthracen-9,10-diamin Zu einer mit N₂ gesättigten Lösung von N-Phenyl-N-(4-methylnaphthyl)-amin (19.1 g, 82 mmol) und 13.1 g (39 mmol) 9,10-Dibromanthracen in 175 ml trockenem Toluol wurden nacheinander im Ar-Gegenstrom 90 mg (0.4 mmol) Pd(OAc)₂, 165 mg (0.8 mmol) P(*^{t}*Bu)₃ und 11.05 g (115 mmol) NaO*^{t}*Bu zugegeben und anschließend für 4 h zum Rückfluss erhitzt. Nach dieser Zeit wurde der Ansatz auf RT abgekühlt und 20 ml 1 %ige NaCN-Lsg. zugetropft, weitere 4 h gerührt und der entstandene Niederschlag abgesaugt, mit H₂O und MeOH gewaschen, getrocknet und viermal aus Toluol/Heptan umkristallisiert. Die Ausbeute betrug 24 g (77%) des Produktes in Form eines farblosen Pulvers mit einer Reinheit von 99.7% (HPLC).
¹H-NMR (d₆ DMSO): [ppm] = 8.08 (d, ³J_{HH} = 8.7 Hz, 2 H), 7.90 (d, ³J_{HH} = 8.0 Hz, 2 H), 7.58 (m, 4 H), 7.33 (m, 4 H), 7.56 (t, ³J_{HH} = 8.0 Hz, 2 H), 7.44 (m, 4 H), 7.28 (d, ³J_{HH} = 7.4 Hz 2 H), 6.94 (m, 10 H), 2.68 (s, 6 H).

### Herstellung von N,N'-(4-bromphenyl)-N,N'-bis(4-methylnaphthyl)-anthracen-9,10-diamin (EM 3)

16.4 g (25.6 mmol) N,N'-Diphenyl-N,N'-bis(4-methylnaphthyl)-anthracen-9,10-diamin wurden in 200 ml CHCl₃ gelöst und bei 0°C unter Wasser- und Luftausschluss 9.4 g (51.2 mmol) NBS sowie 132 mg (0.9 mmol) FeCl₃ zugegeben. Nach 5 min wurde die Reaktion durch Zugabe von 50 ml MeOH gestoppt, der Niederschlag abgesaugt, mit H₂O und MeOH gewaschen und sechsmal aus Toluol/Ethanol umkristallisiert. Es verblieben 11.3 g (55%) eines farblosen Pulvers, das nach HPLC einen Gehalt von 99.9% aufwies.
¹H-NMR (d₆-DMSO): [ppm] = 8.08 (d, ³J_{HH} = 8.4 Hz, 2 H), 7.86 (³J_{HH} = 8.4 Hz, 2 H), 7.59 (m, 4 H), 7.34 (m, 4 H)7.57 (t, ³J_{HH} = 7.7 Hz, 2 H), 7.45 (m, 4 H), 7.30 (³J_{HH} = 7.4 Hz, 2 H), 7.05 (d, ³J_{HH} = 8.7 Hz, 4 H), 6.83 (³J_{HH} = 8.7 Hz, 4 H), 2,68 (s, 6 H).

### A2: Monomere für weitere Einheiten

Die Synthese der weiteren Monomere M1 bis M23 ist bereits in **WO 02/077060** und der darin zitierten Literatur ausführlich beschrieben worden. Die Monomere sind zur besseren Übersicht im folgenden nochmal dargestellt:

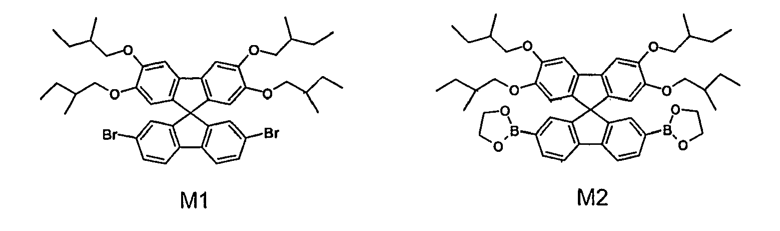

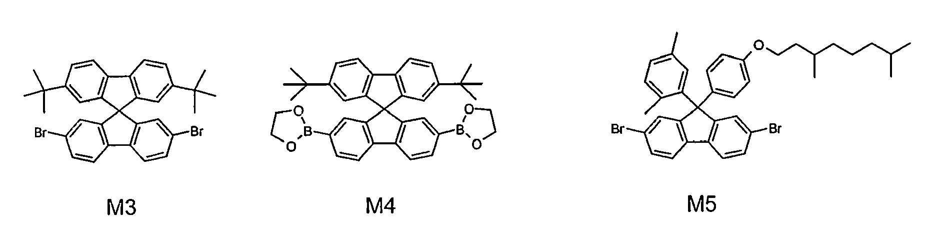

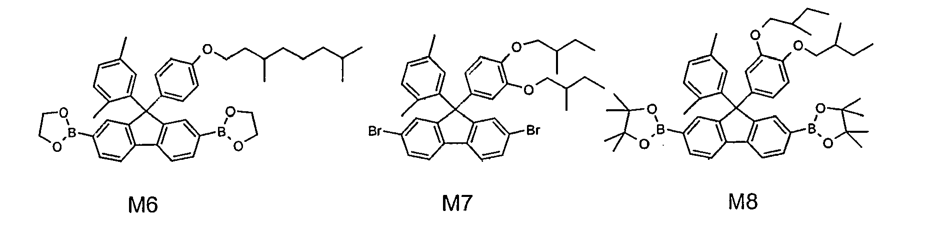

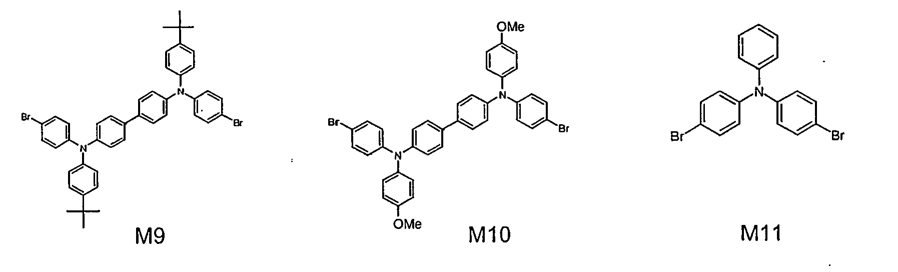

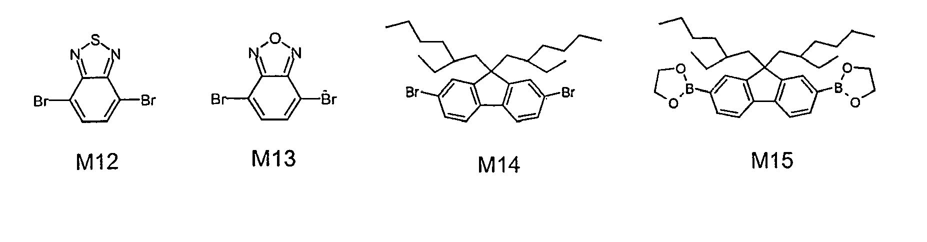

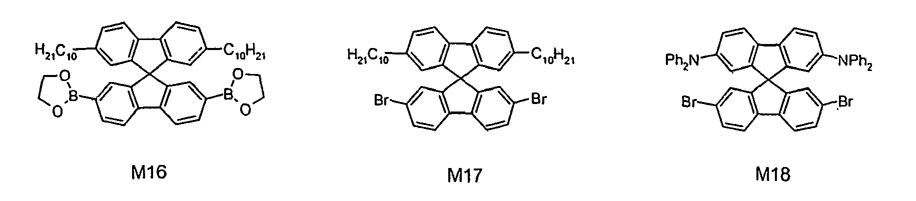

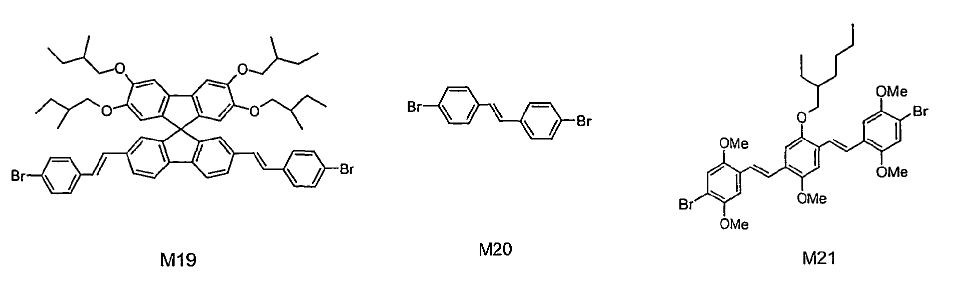

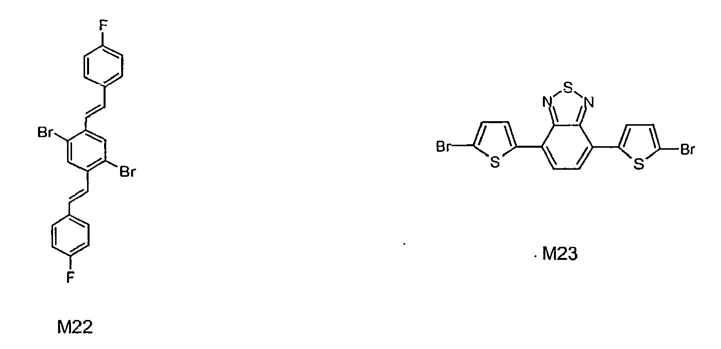

### Teil B: Herstellung der Polymere

### Synthese von Polymer P1:

1,6103 g (2 mmol) Monomer M2, 1,0825 g (1,6 mmol) Monomer M7, 0,3098 g (0,4 mmol) Monomer EM2 und 1,96 g (2.125 Äquivalente) Kaliumphosphat Hydrat wurden gelöst in 19 ml Dioxan, 7 ml Toluol und 3,4 ml H₂O (alle Lösungsmittel sauerstofffrei). Die Reaktionslösung wurde 30 Minuten mit Argon entgast. Dann wurden 0,22 mg (0,025 %) Pd(OAc)₂ und 1,83 mg (0,15 %) P(o-tolyl)₃ als Katalysator zugegeben, und die Lösung wurde 2,5 h unter Rückfluss unter einer Argon-Atmosphäre erhitzt. Die hochviskose Polymerlösung wurde mit 15 ml Dioxan und 35 ml Toluol verdünnt. Dann wurde das Endcapping durchgeführt, indem 0,1 ml Brombenzol und 100 ml Toluol zugegeben wurden, 30 Minuten unter Rückfluss erhitzt, dann Zugabe von 200 mg Benzolboronsäure und 40 ml Toluol und 30 Minuten unter Rückfluss erhitzt. Die Polymerlösung wurde bei 60 °C mit 100 ml 0,01 %iger wässriger NaCN-Lösung 3 h gerührt. Dann wurden die Phasen getrennt, und die organische Phase mit 4 x 100 ml H₂O gewaschen. Das Polymer wurde durch Zugabe des doppelten Volumens an Methanol ausgefällt und filtriert. Weitere Reinigung erfolgte durch Lösen in 200 ml Toluol und 200 ml THF bei 60°C unter Argon, Filtration durch eine Glasfritte und erneute Ausfällung durch Zugabe des doppelten Volumens Methanol. Das Polymer wurde filtriert und unter Vakuum getrocknet. Es wurden 1,98 g (81 % d. Th.) Polymer isoliert, Mw = 1.300.000, Mn = 293.000, Polydispersität = 4,4.

### Synthese von Polymer P2:

3,1706 g (4 mmol) Monomer M2, 1,6237 g (3,2 mmol) Monomer M7, 0,8185 g (0,8 mmol) Monomer M19, 0,8312 g (0,8 mmol) Monomer EM1 und 3,91 g (2.125 Äquivalente) Kaliumphosphat Hydrat wurden gelöst in 37,5 ml Dioxan, 12 ml Toluol und 6,8 ml H₂O (alle Lösungsmittel sauerstofffrei). Die Reaktionslösung wurde 30 Minuten mit Argon entgast. Dann wurden 0,45 mg (0,025 %) Pd(OAc)₂ und 3,65 mg (0,15 %) P(o-tolyl)₃ als Katalysator zugegeben, und die Lösung wurde 2 h unter Rückfluss unter einer Argon-Atmosphäre erhitzt. Die viskose Polymerlösung wurde mit 50 ml Toluol verdünnt. Dann wurde das Endcapping durchgeführt, indem zunächst 100 mg Benzolboronsäure, und nach einer weiteren Stunde Rückfluss 0,1 ml Brombenzol, zugegeben wurden. Die Polymerlösung wurde bei 60°C mit 100 ml 0,01 %iger wässriger NaCN-Lösung 3 h gerührt. Dann wurden die Phasen getrennt, und die organische Phase mit 3 x 100 ml H₂O gewaschen. Die organische Phase wurde mit Toluol auf das vierfache Volumen verdünnt und durch Zugabe der doppelten Menge MeOH gefällt und filtriert. Weitere Reinigung erfolgte durch Lösen in 200 ml THF bei 60 °C unter Argon, Filtration durch eine Glasfritte und erneute Fällung durch Zugabe des doppelten Volumens Methanol. Das Polymer wurde filtriert und unter Vakuum getrocknet. Es wurden 4.23 g (79 % d. Th) Polymer isoliert. M_{w} = 545.000, Mₙ = 193.000; Polydispersität = 2,8.

Weitere Polymere wurden analog den Beschreibungen für P1 und P2 dargestellt. Die chemischen Eigenschaften sind in der folgenden Tabelle zusammengefaßt. Es wurden auch einige Vergleichspolymere (die keine Einheiten gemäß Formel (I) enthalten) dargestellt. Auch diese sind in der Tabelle mit aufgeführt. All diese Polymere wurden auch für einen Einsatz in PLEDs untersucht. Wie PLEDs dargestellt werden können, ist zum einen oben schon ausgeführt und wird detaillierter noch in Teil C beschrieben.
Auch die wichtigsten Device-Eigenschaften (Farbe, Effizienz und Lebensdauer) sind in der Tabelle 1 mit aufgeführt.
Die hier angegebene Lebensdauer bezieht sich auf den sogenannten LT50-Wert, d. h. die Zeit die verstreicht bis die entsprechende PLED nur noch 50% der Anfangshelligkeit aufzeigt.
In Tabelle 2 ist das Verhalten bei höheren Leuchtdichten dokumentiert. Hier kann man sehr gut erkennen, daß der Abfall der Effizienz bei höheren Leuchtdichten bei den erfindungsgemäßen Polymeren deutlich geringer ist, als bei den Vergleichspolymeren gemäß Stand der Technik.

**Tabelle 1.**

| | Anteil der Monomere in der Polymerisation [%] | | | | GPC** | | Elektrolumineszenz*** | | | | Visco.**** |
|---|---|---|---|---|---|---|---|---|---|---|---|
| Polymer (Typ)* | Monom.1 | Monom.2 | Monom. 3 | Monom.4 | M_{W} (·1000 g/mol) | M_{N} (·1000 g/mol) | λₘₐₓ [nm] | Max. Eff [Cd/A] | Spannung bei 100Cd/m² [V] | Lebensdauer bei 100 Cd/m² [Stunden] | Geltemp. [°C] |
| P1 (S) | 50% M2 | 40% M7 | 10% | | 1300 | 293 | 449 | 2,95 | 4,3 | 450 | < 0°C |
| | | | EM2 | | | | | | | | |
| P2 (S) | 50% M2 | 30% M7 | 10% | 10% | 545 | 193 | 459/ | 5,27 | 3,6 | 2500 | < 0°C |
| | | | M19 | EM1 | | | 484 | | | | |
| P3 (S) | 50% M2 | 40% M1 | 10% | | 631 | 164 | 449 | 2,23 | 4,7 | 600 | < 0°C |
| | | | EM1 | | | | | | | | |
| V1 (S) | 50% M2 | 40% M7 | 10% M9 | | 1190 | 199 | 464 | 3,42 | 4,9 | 400 | < 0°C |
| V2 (S) | 50% M2 | 40% M7 | 10% | 10% M9 | 464 | 126 | 459/ | 5,31 | 4,2 | 1800 | < 0°C |
| | | | M19 | | | | 484 | | | | |

| | | | | | | | | | | | |
|---|---|---|---|---|---|---|---|---|---|---|---|
| *S = Durch Suzuki-Polymerisation hergestellt (vgl. Bsp. P1), Y = Durch Yamamoto-Polymerisation hergestellt ** GPC Messungen THF; 1 ml/min, Plgel 10µm Mixed-B 2 x 300 x 7.5 mm², 35°C, RI Detektion wurde gegen Polystyrol geeicht *** Zur Herstellung der Polymer LEDs, siehe Teil C ****Lösungen des Polymers (10mg/ml) in Toluol wurden auf 60°C erwärmt, mit 1 °C/Minute abgekühlt und die Viscosität wurde in einem Brookfield LVDV-III Rheometer (CP-41) gemessen. Bei der so ermittelten Geltemperatur trat ein starker Anstieg in der Viskosität auf. | | | | | | | | | | | |

**Tabelle 2.**

| | **Effizienz (Cd/A) bei einer Helligkeit von...** | | | | |
|---|---|---|---|---|---|
| **Polymer** | 100 Cd/m² | 200 Cd/m² | 1000 Cd/m² | 10000 Cd/m² | 30000 Cd/m² |
| **P1** | 2.8 | 2.9 | 3.1 | 2.8 | 2.4 |
| **P2** | 4.8 | 5.0 | 4.8 | 4.0 | 3.5 |
| **V1** | 3.0 | 3.5 | 2.5 | 2.0 | 1.5 |
| **V2** | 5.0 | 5.2 | 4.3 | 3.3 | 2.6 |

Pulsbedingungen: Die Messungen wurden mit einem "Duty Cycle" von 1:100 und einer Frequenz von 100 Hz durchgeführt.

### Teil C: Herstellung und Charakterisierung von LEDs:

Die Herstellung von LEDs erfolgte nach dem im folgenden skizzierten allgemeinen Verfahren. Dieses mußte im Einzelfall auf die jeweiligen Gegebenheiten (z. B. Polymerviskosität und optimale Schichtdicke des Polymers im Device) angepaßt werden. Die im nachfolgenden beschriebenen LEDs waren jeweils Zweischichtsysteme, d. h. Substrat//ITO//PEDOT//Polymer//Kathode.
PEDOT ist ein Polythiophen-Derivat.

### Allgemeines Verfahren zur Herstellung von hocheffizienten, langlebigen LEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z.B. Seifenlösung, Millipore-Wasser, Isopropanol).
Zur Trocknung werden sie mit einer N₂-Pistole abgepustet und in einem Exsikkator gelagert. Vor der Beschichtung mit dem Polymer werden sie mit einem Ozon-Plasma-Gerät für ca. 20 Minuten behandelt. Von dem jeweiligen Polymer wird eine Lösung (in der Regel mit einer Konzentration von 4-25 mg/ml in beispielsweise Toluol, Chlorbenzol, Xylol:Cyclohexanon (4:1)) angesetzt und durch Rühren bei Raumtemperatur gelöst. Je nach Polymer kann es auch vorteilhaft sein, für einige Zeit bei 50 - 70 °C zu rühren. Hat sich das Polymer vollständig gelöst, wird es durch einen 5µm Filter filtriert und bei variablen Geschwindigkeiten (400-6000) mit einem Spin-coater aufgeschleudert. Die Schichtdicken können dadurch im Bereich von ca. 50 und 300nm variiert werden. Vorab wird meist auf das (strukturierte) ITO ein leitfähiges Polymer, bevorzugt gedoptes PEDOT oder PANI, aufgebracht.
Auf die Polymerfilme werden noch Elektroden aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode (z. B. Ba, Yb, Ca) als Kathode kontaktiert und die Device-Parameter bestimmt.
Die mit den beschriebenen Polymeren erhaltenen Resultate sind in den Tabellen in Teil B zusammengefaßt.

## Patentansprüche

1. Konjugierte Polymere enthaltend mindestens 1 mol%, Einheiten gemäß Formel (I), 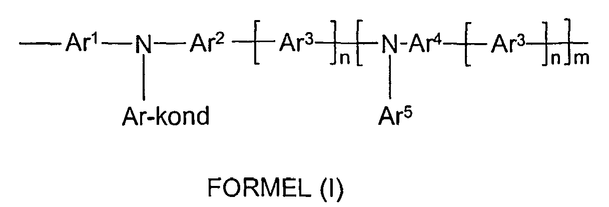 wobei die Symbole und Indizes folgende Bedeutung besitzen:
Ar¹, Ar³ sind bei jedem Auftreten gleich oder verschieden einem aromatischen oder heteroaromatischen Ringsystem mit 2 bis 40 C-Atomen, welches substituiert oder auch unsubstituiert sein kann; die möglichen Substituenten R1 können dabei potentiell an jeder freien Position sitzen;
Ar², Ar⁴ sind bei jedem Auftreten gleich oder verschieden Ar¹, Ar³ bzw. einer substituierten bzw. unsubstituierten Stilbenylen- bzw. Tolanyleneinheit;
Ar-kond ist bei jedem Auftreten gleich oder verschieden einem aromatischen oder heteroaromatischen Ringsystem, welches mindestens 9, höchstens aber 40 Atome (C- oder Heteroatome) im konjugierten System besitzt, welches substituiert oder auch unsubstituiert sein kann und welches aus mindestens zwei kondensierten Ringen besteht; die möglichen Substituenten R1 können dabei potentiell an jeder freien Position sitzen;
Ar⁵ ist gleich oder verschieden bei jedem Auftreten entweder einem aromatischen oder heteroaromatischen Ringsystem mit 2 bis 40 C-Atomen, welches substituiert oder auch unsubstituiert sein kann oder Ar-kond; die möglichen Substituenten R1 können dabei potentiell an jeder freien Position sitzen;
m, n sind gleich oder verschieden bei jedem Auftreten 0, 1 oder 2;
R1 ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R2, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R1 substituiert sein können, oder Cl, F, CN, N(R2)₂, B(R2)₂, wobei auch zwei oder mehrere Reste R1 miteinander ein Ringsystem bilden können;
R2 ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R1 substituiert sein können.
mit der Maßgabe, das die Einheiten gemäß den Strukturen (1) bis (3) 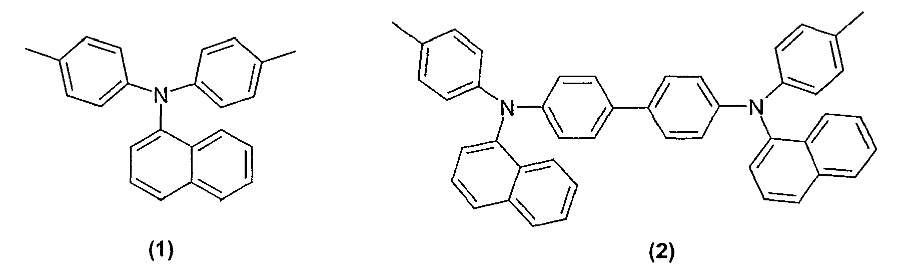 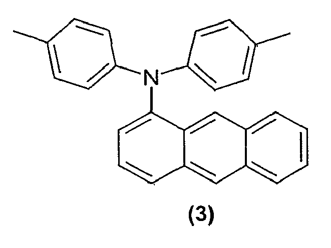 ausgenommen sind, wenn das konjugierte Polymer Metallkomplexe enthält welche einen Transfer von Singulett-Excitonen zu Triplett-Excitonen ermöglichen.

2. Polymere gemäß Anspruch 1 **dadurch gekennzeichnet, daß** diese noch weitere Strukturelemente enthalten.

3. Polymere gemäß Anspruch 2 **dadurch gekennzeichnet, daß** die weiteren Strukturelemente aus den Gruppen meta- oder para-Phenylene, 1,4-Naphthylene, 9,10-Anthracenylene, 2,7-Phenanthrenylene, 1,6- bzw. 2,7- bzw. 4,9-Pyrenylene oder 2,7-Tetrahydropyrenylene, Oxadiazolylene, 2,5-Thiophenylene, 2,5-Pyrrolylene, 2,5-Furanylene, 2,5-Pyridylene, 2,5-Pyrimidinylene, 3,6- bzw. 2,7-Carbazolylene oder 5,8-Chinolinylene, Fluorenylene, Spiro-9,9'-bifluorenylene, Indenofluorenylene ausgewählt sind.

4. Polymere gemäß Anspruch 2 und/oder 3 **dadurch gekennzeichnet, daß** die weiteren Strukturelemente aus Gruppen, die die Farbe der Emission verschieben, damit auch die Bandlücke des Polymers verändern und somit i. d. R. auch die Ladungsinjektions- bzw. -transporteigenschaften verändern, ausgewählt sind.

5. Polymere gemäß einem oder mehreren der Ansprüche 2 bis 4 **dadurch gekennzeichnet, daß** die weiteren Strukturelemente aus den Gruppen Arylen-vinylen- oder Arylen-acetylen-strukturen, wie substituierten oder unsubstituierten Stilbenylene, Tolanylene, Bisstyrylarylene, Bis(arylacetylen)-arylene oder größeren aromatischen Einheiten, wie Chrysenen, Naphthacenen, Pentacenen, Perylenen oder Coronenen, ausgewählt sind.

6. Polymere gemäß einem oder mehreren der Ansprüche 2 bis 5 **dadurch gekennzeichnet, daß** als weitere Strukturelemente Metallkomplexe anwesend sind, welche einen Transfer von sogenannten Singulett-Excitonen zu Triplett-Excitonen ermöglichen und welche aus dem Triplettzustand Licht emittieren.

7. Polymere gemäß Anspruch 6 **dadurch gekennzeichnet, daß** die weiteren Strukturelemente d- und f-Übergangsmetalle, enthalten.

8. Polymere gemäß Anspruch 7 **dadurch gekennzeichnet, daß** die weiteren Strukturelemente Metalle der 8 bis 10 Gruppe enthalten.

9. Polymere gemäß einem oder mehreren der Ansprüche 1 bis 8 **dadurch gekennzeichnet, daß** für die Symbole und Indizes folgendes gilt:
Ar¹, Ar², Ar³, Ar⁴ sind bei jedem Auftreten gleich oder verschieden einem aromatischen oder heteroaromatischen Ringsystem, ausgewählt aus Thiophen, Benzol, Pyridin, Fluoren, Spirobifluoren, Anthracen, oder Naphthalin, welche an den freien Positionen 0 bis 2 Substituenten R1 tragen;
Ar-kond ist bei jedem Auftreten gleich oder verschieden einem aromatischen oder heteroaromatischen Ringsystem, ausgewählt aus Naphthalin, Chinolin, Anthracen, Phenanthren oder Pyren, welche an den freien Positionen 0 bis 2 Substituenten R1 tragen;
Ar⁵ ist bei jedem Auftreten gleich oder verschieden einem aromatischen oder heteroaromatischen Ringsystem, ausgewählt aus Benzol, Naphthalin, Chinolin, Anthracen, Phenanthren oder Pyren, welche an den freien Positionen 0 bis 2 Substituenten R1 tragen;
n, m, R1, R2 sind wie in Anspruch 1 beschrieben.

10. Polymere gemäß einem oder mehreren der Ansprüche 1 bis 9 **dadurch gekennzeichnet, daß** die Strukturelemente vom Typ Formel (I) aus den Formeln (II) bis (XXXIV) ausgewählt werden.

11. Polymere gemäß einem oder mehreren der Ansprüche 1 bis 10 **dadurch gekennzeichnet, daß** im Durchschnitt pro Wiederholeinheit mindestens 2 nicht-aromatische C-Atome in den Substituenten vorhanden sind.

12. Polymere gemäß einem oder mehreren der Ansprüche 1 bis 11 **dadurch gekennzeichnet, daß** keine langkettigen Substituenten mit mehr als 12 C-Atomen in einer linearen Kette enthalten sind.

13. Polymere gemäß einem oder mehreren der Ansprüche 1 bis 12 **dadurch gekennzeichnet, daß** diese durch SUZUKI-Kupplung, YAMAMOTO-Kupplung, STILLE-Kupplung oder HARTWIG-BUCHWALD-Kupplung hergestellt werden.

14. Verwendung eines Polymers gemäß einem oder mehreren der Ansprüche 1 bis 13 in Organischen Integrierten Schaltungen (O-ICs), in Organischen Feld-Effekt-Transistoren (OFETs), in Organischen Dünnfilmtransistoren (OTFTs), in Organischen Solarzellen (O-SCs), Organischen Leuchtdioden (OLED) oder Organischen Laserdioden (O-Laser).

15. Elektronisches Bauteil, welche eine oder mehrere aktiven Schichten umfaßt, wobei mindestens eine dieser aktiven Schichten ein oder mehrere Polymere gemäß einem oder mehreren der Ansprüche 1 bis 13 enthält.

## Claims

1. Conjugated polymers containing at least one mol% of units of the formula (I) 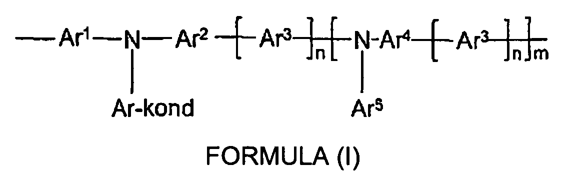 where the symbols and indices have the following meaning:
Ar¹, Ar³ are on each occurrence, identically or differently, an aromatic or heteroaromatic ring system having 2 to 40 C atoms, which may be substituted or also unsubstituted; the possible substituents R1 may potentially sit in any free position;
Ar², Ar⁴ are on each occurrence, identically or differently, Ar¹, Ar³ or a substituted or unsubstituted stilbenylene or tolanylene unit;
Ar-cond is on each occurrence, identically or differently, an aromatic or heteroaromatic ring system which has at least 9, but at most 40 atoms (C or heteroatoms) in the conjugated system, which may be substituted or also unsubstituted and which consists of at least two condensed rings; the possible substituents R1 may potentially sit in any free position;
Ar⁵ is, identically or differently on each occurrence, either an aromatic or heteroaromatic ring system having 2 to 40 C atoms, which may be substituted or also unsubstituted, or Ar-cond; the possible substituents R1 may potentially sit in any free position;
m, n are, identically or differently on each occurrence, 0, 1 or 2;
R1 is on each occurrence, identically or differently, a straight-chain, branched or cyclic alkyl or alkoxy chain having 1 to 22 C atoms, in which, in addition, one or more non-adjacent C atoms may be replaced by N-R2, O, S, -CO-O-, O-CO-O, where, in addition, one or more H atoms may be replaced by fluorine, an aryl or aryloxy group having 5 to 40 C atoms, in which, in addition, one or more C atoms may be replaced by O, S or N, which, in addition, may be substituted by one or more non-aromatic radicals R1, or Cl, F, CN, N(R2)₂, B(R2)₂, where, in addition, two or more radicals R1 may form a ring system with one another;
R2 is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O, where, in addition, one or more H atoms may be replaced by fluorine, an aryl group having 5 to 40 C atoms, in which, in addition, one or more C atoms may be replaced by O, S or N, which, in addition, may be substituted by one or more non-aromatic radicals R1;
with the proviso that the units of structures (1) to (3) 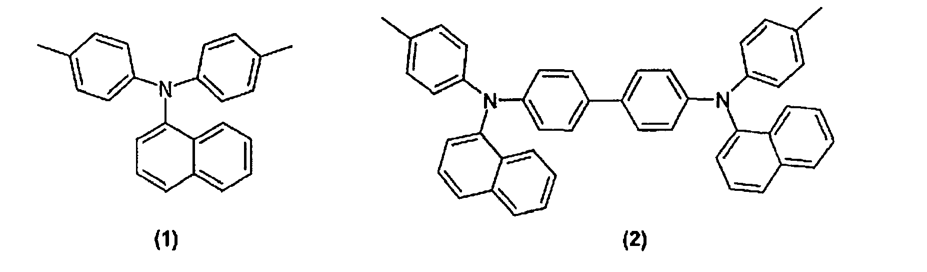 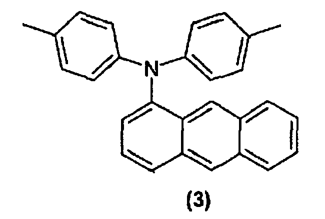 are excluded if the conjugated polymer contains metal complexes
which facilitate transfer of singlet excitons to triplet excitons.

2. Polymers according to Claim 1, **characterised in that** they contain further structural elements.

3. Polymers according to Claim 2, **characterised in that** the further structural elements are selected from the groups meta- or para-phenylenes, 1,4-naphthylenes, 9,10-anthracenylenes, 2,7-phenanthrenylenes, 1,6- or 2,7- or 4,9-pyrenylenes or 2,7-tetrahydropyrenylenes, oxadiazolylenes, 2,5-thiophenylenes, 2,5-pyrrolylenes, 2,5-furanylenes, 2,5-pyridylenes, 2,5-pyrimidinylenes, 3,6- or 2,7-carbazolylenes or 5,8-quinolinylenes, fluorenylenes, spiro-9,9'-bifluorenylenes, indenofluorenylenes.

4. Polymers according to Claim 2 and/or 3, **characterised in that** the further structural elements are selected from groups which shift the colour of the emission, thus also modify the band gap of the polymer and thus generally also modify the charge-injection or -transport properties.

5. Polymers according to one or more of Claims 2 to 4, **characterised in that** the further structural elements are selected from the groups arylene-vinylene or arylene-acetylene structures, such as substituted or unsubstituted stilbenylenes, tolanylenes, bisstyrylarylenes, bis(aryl-acetylene)arylenes or larger aromatic units, such as chrysenes, naphthacenes, pentacenes, perylenes or coronenes.

6. Polymers according to one or more of Claims 2 to 5, **characterised in that** the further structural elements present are metal complexes which facilitate transfer of so-called singlet excitons to triplet excitons and which emit light from the triplet state.

7. Polymers according to Claim 6, **characterised in that** the further structural elements contain d and f transition metals.

8. Polymers according to Claim 7, **characterised in that** the further structural elements contain metals from groups 8 to 10.

9. Polymers according to one or more of Claims 1 to 8, **characterised in that** the following applies to the symbols and indices:
Ar¹, Ar², Ar³, Ar⁴ are on each occurrence, identically or differently, an aromatic or heteroaromatic ring system selected from thiophene, benzene, pyridine, fluorene, spirobifluorene, anthracene or naphthalene, which carry 0 to 2 substituents R1 in the free positions;
Ar-cond is on each occurrence, identically or differently, an aromatic or heteroaromatic ring system selected from naphthalene, quinoline, anthracene, phenanthrene or pyrene, which carry 0 to 2 substituents R1 in the free positions;
Aᵣ⁵ is on each occurrence, identically or differently, an aromatic or heteroaromatic ring system selected from benzene, naphthalene, quinoline, anthracene, phenanthrene or pyrene, which carry 0 to 2 substituents R1 in the free positions;
n, m, R1, R2 are as described in Claim 1.

10. Polymers according to one or more of Claims 1 to 9, **characterised in that** the structural elements of the formula (I) type are selected from the formulae (II) to (XXXIV).

11. Polymers according to one or more of Claims 1 to 10, **characterised in that** at least 2 non-aromatic C atoms per recurring unit are on average present in the substituents.

12. Polymers according to one or more of Claims 1 to 11, **characterised in that** no long-chain substituents having more than 12 C atoms are present in a linear chain.

13. Polymers according to one or more of Claims 1 to 12, **characterised in that** they are prepared by SUZUKI coupling, YAMAMOTO coupling, STILLE coupling or HARTWIG-BUCHWALD coupling.

14. Use of a polymer according to one or more of Claims 1 to 13 in organic integrated circuits (O-ICs), in organic field-effect transistors (OFETs), in organic thin-film transistors (OTFTs), in organic solar cells (O-SCs), organic light-emitting diodes (OLEDs) or organic laser diodes (O-lasers).

15. Electronic component which comprises one or more active layers, where at least one of these active layers comprises one or more polymers according to one or more of Claims 1 to 13.

## Revendications

1. Polymères conjugués contenant au moins un mol% d'unités de la formule (I) 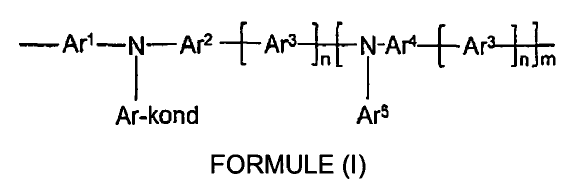 où les symboles et les indices présentent la signification qui suit :
Ar¹, Ar³ sont, lors de chaque occurrence, de manière identique ou différente, un système d'anneau aromatique ou hétéro-aromatique comportant de 2 à 40 atomes de C, qui peut être substitué ou également non substitué ; les substituants possibles R1 peuvent potentiellement résider au niveau de n'importe quelle position libre ;
Ar², Ar⁴ sont, lors de chaque occurrence, de manière identique ou différente, Ar¹, Ar³ ou une unité de stilbénylène ou de tolanylène substitué ou non substitué;
Ar-cond est, lors de chaque occurrence, de manière identique ou différente, un système d'anneau aromatique ou hétéro-aromatique qui comporte au moins 9 mais au plus 40 atomes (C ou des hétéroatomes) dans le système conjugué, qui peut être substitué ou également non substitué et qui est constitué par au moins deux anneaux condensés ; les substituants possibles R1 peuvent potentiellement résider au niveau de n'importe quelle position libre ;
Ar⁵ est , de manière identique ou différente lors de chaque occurrence, soit un système d'anneau aromatique, soit un système d'anneau hétéroaromatique comportant de 2 à 40 atomes de C, qui peut être substitué ou également non substitué, ou Ar-cond ; les substituants possibles R1 peuvent potentiellement résider au niveau de n'importe quelle position libre ;
m, n sont, de manière identique ou différente lors de chaque occurrence, 0, 1 ou 2 ;
R1 est, lors de chaque occurrence, de manière identique ou différente, une chaîne alkyle ou alkoxy en chaîne droite, ramifiée ou cyclique comportant de 1 à 22 atomes de C où, en plus, un ou plusieurs atomes de C non adjacents peuvent être remplacés par N-R2, O, S, -CO-O-, O-CO-O, où, en plus, un ou plusieurs atomes de H peuvent être remplacés par fluor, un groupe aryle ou aryloxy comportant de 5 à 40 atomes de C où, en plus, un ou plusieurs atomes de C peuvent être remplacés par O, S ou N, qui, en outre, peut être substitué par un ou plusieurs radicaux non aromatiques R1, ou CI, F, CN, N(R2)₂, B(R2)₂, où, en plus, deux radicaux R1 ou plus peuvent former un système d'anneau l'un avec l'autre ou les uns avec les autres ;
R2 est, lors de chaque occurrence, de manière identique ou différente, H, une chaîne alkyle en chaîne droite, ramifiée ou cyclique comportant de 1 à 22 atomes de C où, en plus, un ou plusieurs atomes de C non adjacents peuvent être remplacés par O, S, -CO-O-, O-CO-O, où, en plus, un ou plusieurs atomes de H peuvent être remplacés par fluor, un groupe aryle comportant de 5 à 40 atomes de C, où, en plus, un ou plusieurs atomes de C peuvent être remplacés par O, S ou N, qui, en plus, peut être substitué par un ou plusieurs radicaux non aromatiques R1 ;
étant entendu que les unités des structures (1) à (3) 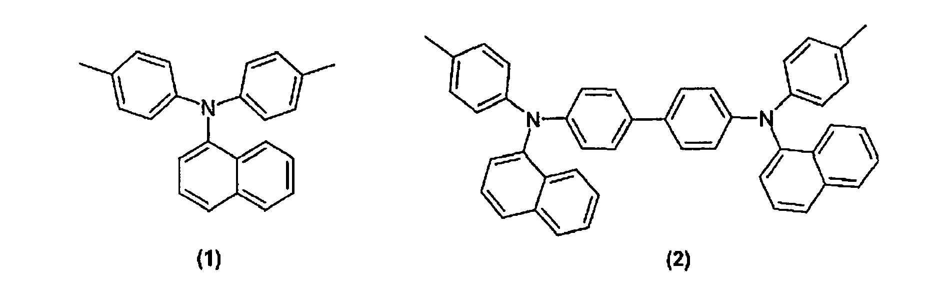 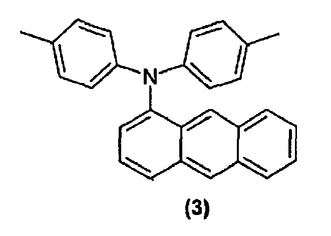 sont exclues si le polymère conjugué contient des complexes métalliques qui facilitent un transfert d'excitons singlets sur des excitons triplets.

2. Polymères selon la revendication 1, **caractérisés en ce qu'**ils contiennent d'autres éléments structurels.

3. Polymères selon la revendication 2, **caractérisés en ce que** les autres éléments structurels sont choisis parmi les groupes méta- ou paraphénylènes, 1,4-naphthylènes, 9,10-anthracénylènes, 2,7-phénanthrénylènes, 1,6- ou 2,7- ou 4,9-pyrènylènes ou 2,7-tétrahydropyrènylènes, oxadiazolylènes, 2,5-thiophénylènes, 2,5-pyrrolylènes, 2,5-furanylènes, 2,5-pyridylènes, 2,5-pyrimidinylènes, 3,6- ou 2,7-carbazolylènes ou 5,8-quinolinylènes, fluorènylènes, spiro-9,9'-bifluorénylènes, indénofluorénylènes.

4. Polymères selon la revendication 2 et/ou 3, **caractérisés en ce que** les autres éléments structurels sont choisis parmi des groupes qui décalent la couleur de l'émission, qui par conséquent modifient également la bande interdite du polymère et qui par conséquent modifient généralement également les propriétés d'injection de charge ou de transport de charge.

5. Polymères selon une ou plusieurs des revendications 2 à 4, **caractérisés en ce que** les autres éléments structurels sont choisis parmi les groupes structures arylène-vinylène ou arylène-acétylène, tels que stilbenylènes, tolanylènes, bisstyrylarylènes, bis(arylacétylène) arylènes ou unités aromatiques plus grandes substituées ou non substituées telles que chrysènes, naphthacènes, pentacènes, pérylènes ou coronènes.

6. Polymères selon une ou plusieurs des revendications 2 à 5, **caractérisés en ce que** les autres éléments structurels présents sont des complexes métalliques qui facilitent le transfert de ce que l'on appelle des excitons singlets sur des excitons triplets et qui émettent de la lumière depuis l'état triplet.

7. Polymères selon la revendication 6, **caractérisés en ce que** les autres éléments structurels contiennent des métaux de transition d et f.

8. Polymères selon la revendication 7, **caractérisés en ce que** les autres éléments structurels contiennent des métaux pris parmi les groupes 8 à 10.

9. Polymères selon une ou plusieurs des revendications 1 à 8, **caractérisés en ce que** ce qui suit s'applique aux symboles et aux indices :
Ar¹, Ar², Ar³, Ar⁴ sont, lors de chaque occurrence, de manière identique ou différente, un système d'anneau aromatique ou hétéroaromatique choisi parmi thiophène, benzène, pyridine, fluorène, spirobifluorène, anthracène ou naphtalène, qui sont porteurs de 0 à 2 substituants R1 au niveau des positions libres ;
Ar-cond est, lors de chaque occurrence, de manière identique ou différente, un système d'anneau aromatique ou hétéroaromatique choisi parmi naphthalène, quinoline, anthracène, phénanthrène ou pyrène, qui est porteur de 0 à 2 substituants R1 au niveau des positions libres ;
Ar⁵ est, lors de chaque occurrence, de manière identique ou différente, un système d'anneau aromatique ou hétéroaromatique choisi parmi benzène, naphthalène, quinoline, anthracène, phénanthrène ou pyrène, qui est porteur de 0 à 2 substituants R1 au niveau des positions libres ;
n, m, R1, R2 sont comme décrit selon la revendication 1.

10. Polymères selon une ou plusieurs des revendications 1 à 9, **caractérisés en ce que** les éléments structurels du type de la formule (I) sont choisis parmi les formules (II) à (XXXIV).

11. Polymères selon une ou plusieurs des revendications 1 à 10, **caractérisés en ce qu'**au moins deux atomes de C non aromatiques par unité récurrente sont en moyenne présents dans les substituants.

12. Polymères selon une ou plusieurs des revendications 1 à 11, **caractérisés en ce qu'**aucun substituant en chaîne longue comportant plus de 12 atomes de C n'est présent dans une chaîne linéaire.

13. Polymères selon une ou plusieurs des revendications 1 à 12, **caractérisés en ce qu'**ils sont préparés au moyen d'un couplage SUZUKI, d'un couplage YAMAMOTO, d'un couplage STILLE ou d'un couplage HARTW IG-BUCHWALD.

14. Utilisation d'un polymère selon une ou plusieurs des revendications 1 à 13 dans des circuits intégrés organiques (O-IC), dans des transistors à effet de champ organiques (OFET), dans des transistors à film mince organiques (OTFT), dans des cellules solaires organiques (O-SC), dans des diodes émettrices de lumière organiques (OLED) ou dans des diodes laser organiques (O-laser).

15. Composant électronique qui comprend une ou plusieurs couches actives où au moins l'une de ces couches actives comprend un ou plusieurs polymères selon une ou plusieurs des revendications 1 à 13.
